(19) Europäisches Patentamt
European Patent Office
Office européen des brevets

(11) **EP 2 110 709 B1**

(12) **EUROPÄISCHE PATENTSCHRIFT**

(45) Veröffentlichungstag und Bekanntmachung des Hinweises auf die Patenterteilung:
**05.06.2013 Patentblatt 2013/23**

(51) Int Cl.:
*G03F 7/20* *(2006.01)*　　*H05K 3/00* *(2006.01)*

(21) Anmeldenummer: **09005337.2**

(22) Anmeldetag: **14.04.2009**

(54) **Lithografiebelichtungseinrichtung**

Lithography exposure device

Dispositif d'éclairage par lithographie

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**
Benannte Erstreckungsstaaten:
**AL BA RS**

(30) Priorität: **14.04.2008　DE 102008018763**

(43) Veröffentlichungstag der Anmeldung:
**21.10.2009　Patentblatt 2009/43**

(73) Patentinhaber: **Limata GmbH**
**85737 Ismaning (DE)**

(72) Erfinder:
• **Nagel, Matthias**
**81927 München (DE)**
• **Heim, Attila**
**80024 Taufkirchen (DE)**
• **Bartsch, Kristin**
**81925 München (DE)**

(74) Vertreter: **Vossius & Partner**
**Siebertstrasse 4**
**81675 München (DE)**

(56) Entgegenhaltungen:
WO-A-2006/074812　　US-A- 5 745 296
US-A1- 2003 201 399

## Beschreibung

### Gebiet der Erfindung

Die vorliegende Erfindung betrifft eine Lithografiebelichtungseinrichtung, insbesondere eine Lithografiebelichtungseinrichtung zum Belichten eines mit einer lichtempfindlichen Schicht beschichteten Substrats zur Herstellung einer Leiterplatte bzw. Platine, sowie das entsprechende Verfahren zur Belichtung mit der erfindungsgemäßen Lithografiebelichtungseinrichtung. Insbesondere betrifft die Erfindung eine Lithografiebelichtungseinrichtung mit mindestens einer UV-LED aufweisenden Belichtungseinrichtung, die relativ zum Substrat beweglich ist, um Strukturen, insbesondere Schaltstrukturen in Abhängigkeit der Bewegung auf dem Substrat zu erzeugen.

### Hintergrund der Erfindung

Eine Leiterplatte (Leiterkarte, Platine) ist ein Träger bzw. Substrat aus isolierendem Material mit festhaftenden leitenden Verbindungen. Eine Leiterplatte dient der mechanischen Befestigung und elektrischen Verbindung elektronischer Bauteile. Die Verbindungsleitungen (Leiterbahnen) werden zumeist durch Masken-Ätzen (geätzte Leiterplatte, engl. etched wiring board = EWB) aus einer dünnen Schicht leitfähigen Materials, beispielsweise Kupfer, auf einem isolierenden Substrat (dem sogenannte Basismaterial) hergestellt.

Bei der Erzeugung von Schaltstrukturen bzw. Verbindungsleitungen mittels Masken-Ätzen wird üblicherweise ein Schaltungsmuster auf einer Abdeckmaske bereitgestellt. Eine lichtempfindliche Schicht (Fotoresist, bzw. Fotolack), die auf einem mit einer leitfähigen Beschichtung versehenen Plattenrohling aufgetragen ist, wird durch die Abdeckmaske belichtet, wodurch das Schaltungsmuster von der Abdeckmaske auf den Fotoresist übertragen wird.

Durch die Belichtung wird die Beschaffenheit des Resists so verändert, dass die belichteten und unbelichteten Strukturen unterschiedlich von einer Entwicklerflüssigkeit lösbar sind. So können nach der Belichtung des Fotoresists durch die Maske mit dem gewünschten Platinenlayout, je nach verwendetem Fotoresist, entweder die belichteten oder die unbelichteten Anteile des Lacks in einer passenden Entwicklerlösung gelöst und entfernt werden. Bringt man die so behandelte Leiterplatte in eine geeignete Ätzlösung (z. B. in Wasser gelöstes Eisen(III)-chlorid oder Natriumpersulfat oder mit Salzsäure+$H_2O_2$), so wird nur der freigelegte Teil der metallisierten Oberfläche angegriffen; die vom Fotoresist bedeckten Anteile bleiben erhalten, weil der Lack beständig gegen die Ätzlösung ist.

Für die Belichtung des Fotoresists wird ein Belichtungsmittel mit bestimmten auf das lichtempfindliche Material abgestimmten erforderlichen Strahlungseigenschaften bzgl. Wellenlänge und Intensität eingesetzt. Die meisten handelsüblichen Fotoresits sind besonders empfindlich auf UV-Licht, insbesondere auf Licht im Wellenbereich zwischen 350 nm - 450 nm. Als herkömmliche Belichtungsmittel werden Glühlampen mit hohem UV-Anteil bzw. Leuchtstoffröhren verwendet. Die zum Großteil zur Belichtung eingesetzten Leuchtstoffröhren haben jedoch ein relativ breiteres Spektrum. D.h. ein hohen Anteil des emittierten Lichtes ist im Wellenlängenbereich des sichtbarem Lichtes auf den der Fotoresits nicht empfindlich ist, wodurch der Wirkungsgrad solcher Leuchtstoffröhren nicht optimal ist.

Das Entwerfen der Schaltungsmuster erfolgt heute meist mittels Software am Computer. Dementsprechend gibt es Lithografiebelichtungseinrichtungen, die das Schaltungsmuster direkt mit einer Belichtungseinrichtung auf den Fotoresits übertragen und keine Maske benötigen. Beispielsweise wird in den Anmeldungen WO 98/00760 und EP 1 319 984 eine Lithografiebelichtungseinrichtungen offenbart, bei denen der Fotoresist mit einer Laserstrahlungsquelle, die Laserlicht im blauen Spektralbereich, im nahen UV oder im UV Bereich emittiert, belichtet wird. Der Laserstrahl hat den Vorteil, dass er extrem gebündelt ist, wodurch einzelne Leiterbahnen direkt auf den Fotoresist belichtet werden können bei entsprechender Bewegung des Laserstrahls.

Laser, die Licht in einer Intensität emittieren die eine schnelle Belichtung eines Fotoresists ermöglichen sind jedoch sehr teuer. Um eine ausreichende Intensität bereitzustellen können auch mehrere Laser verwendet werden, wie beispielsweise in der WO 98/00760 und der EP 1 319 984 offenbart. Die Kosten für derartige Lithografiebelichtungseinrichtungen bleiben jedoch auf einem hohen Niveau. US 5 745 296 Offenbart eine Lithegraphie belichtungseinrichtung mit mehreren Leuchtdioden zum direkten Belichten eines Musters auf ein Substrat, in den das Substrat relativ zur Belichtungseinrichtung bewegt wird und das Licht auf dem Substrat in Flecken gebündelt wird.

Es ist somit eine Aufgabe der Erfindung, die bekannten Belichtungsvorrichtungen für Schaltungsplatten so zu verbessern, dass sie kostengünstiger in der Konstruktion, in der Anwendung und im Service sind, und dennoch flexibel eingesetzt werden können.

Die Aufgabe der vorliegenden Erfindung wird durch die unabhängigen Patentansprüche gelöst. Die abhängigen Ansprüche beschreiben weitere bevorzugte Ausführungsformen und Abwandlungen der Erfindung.

### Zusammenfassung der Erfindung

Die erfindungsgemäße Lithografiebelichtungseinrichtung umfasst eine Belichtungseinrichtung zum Belichten eines Substrats mit lichtempfindlicher Schicht (Fotoresist) und eine Bewegungseinrichtung, die während der Belichtung eine Relativbewegung zwischen der Belichtungseinrichtung und dem Substrat erzeugt, wobei die Belichtungseinrichtung mindestens eine Lichtquelle mit mindestens einer UV-Licht emittierenden Leuchtdiode (UV-LED) aufweist. Insbesondere handelt es sich bei der erfindungsgemäßen Lithografiebelichtungseinrichtung um eine maskenlose Direktbelichtungseinrichtung, mit der Muster bzw. Strukturen aufgrund der Relativbewegung während der Belichtung direkt auf das Substrat belichtet werden können. Entsprechend ist die Belichtungseinrichtung zum direkten Belichten eines Musters bzw. einer Struktur so angepasst, dass das von der Lichtquelle emittierte Licht auf einen Belichtungsfleck auf dem Substrat gebündelt wird, vorzugsweise in einem Brennpunkt auf dem Substrat fokussiert wird. Um die gewünschte Struktur auf dem Substrat zu belichten ist die Lithografiebelichtungseinrichtung so angepasst, dass während der Belichtung eine Relativbewegung in zwei Dimensionen (entlang zweier senkrecht zueinander stehender Achsen) stattfinden kann, wobei die Intensität des auf das Substrat auftreffenden Lichtes während der Belichtungseinrichtung veränderbar (steuerbar) ist.

Die Belichtungseinrichtung (im Folgenden werden die Begriffe Belichtungseinrichtung und Belichtungseinheit synonym verwendet), die zumindest eine Leuchtdiode (LED) aufweist, die zumindest UV-Licht mit einem Abstrahl- bzw. Halbwertswinkel $\alpha'$ emittiert, weist optische Mittel auf, die den Abstrahl- bzw. Halbwertswinkel $\alpha'$ des emittierten Lichtes stufenweise verkleinern und schließlich auf dem Substrat in einem Belichtungsfleck bündeln bzw. fokussieren. Vorzugsweise enthält die Belichtungseinrichtung zwei oder mehr Stufen für die stufenweise Verkleinerung des Abstrahl- bzw. Halbwertswinkels, wobei das Verhältnis des verkleinerten Abstrahl- bzw. Halbwertswinkels $\beta'$ zu $\alpha'$ vorzugsweise kleiner als 0,1 ist ($\alpha'/\beta' > 10$) jedoch vorzugsweise $\alpha'/\beta' > 15$ ist.

Vorzugsweise sind die optischen Mittel zum stufenweise verkleinern des Abstrahl- bzw. Halbwertswinkel $\alpha'$ in einer (ersten), zwei oder mehreren Linsensystemstufe verteilt, wobei die erste Linsensystemstufe optische Mittel aufweist, die das emittierte Licht vorzugsweise durch Lichtbrechung kollimiert, d.h. das emittierte Licht erfährt eine Richtungsänderung aufgrund einer lokalen Änderung ihrer Ausbreitungsgeschwindigkeit, die durch die Brechzahl n den durchwanderten Mediums beschrieben wird. Die erste Linsensystemstufe ist jedoch nicht auf lichtbrechende Linsen beschränkt, sondern kann alternativ oder zusätzlich Spiegelelemente aufweisen.

Um den Belichtungsfleck bzw. Brennpunkt auf dem Substrat zu bündeln bzw. zu fokussieren weist die Belichtungseinrichtung eine zweite Linsensystemstufe auf. Auch die zweite Linsensystemstufe weist vorzugsweise optische Mittel auf, die das emittierte Licht vorzugsweise durch Lichtbrechung kollimiert. Die zweite Linsensystemstufe ist jedoch nicht auf lichtbrechende Linsen beschränkt, sondern kann alternativ oder zusätzlich Spiegelelemente aufweisen.

Der Belichtungsfleck ist vorzugsweise im Wesentlichen näherungsweise rund und hat vorzugsweise einen Durchmesser von ca. 100 μm, weiter bevorzugt einen Durchmesser zwischen 25 - 100 μm und weiter bevorzugt zwischen 25 und 50 μm.

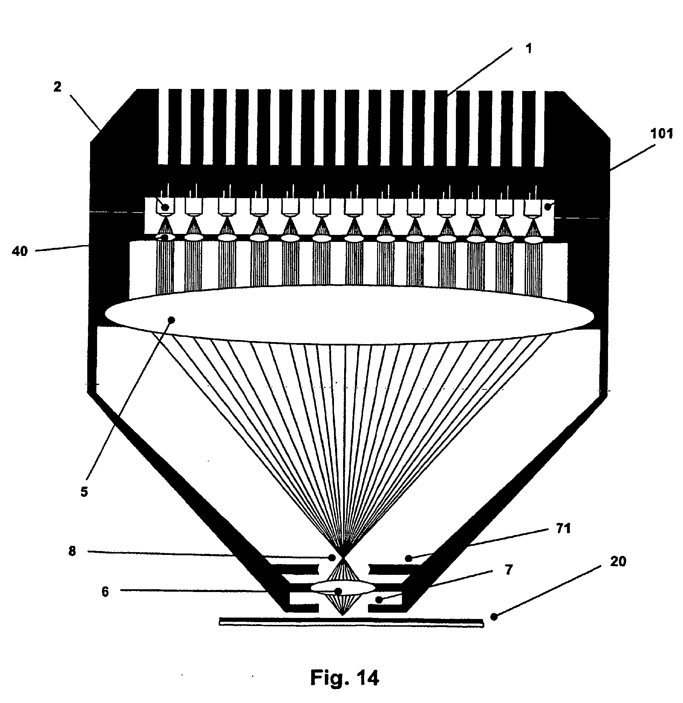

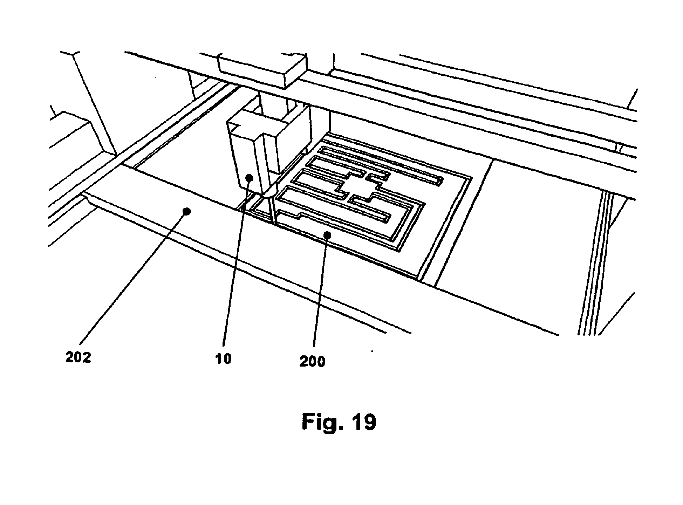

Vorzugsweise wird Licht mit einer Leistung von mindestens 100 mW/cm$^2$, weiter bevorzugt von 0,5 W/cm$^2$ bzw. für Vaporisierungsanwendungen wie beispielsweise in Fig. 19 gezeigt und bei Array-Lichtquellen wie beispielsweise in Fig. 14 von 20 W/cm$^2$ auf das Substrat emittiert.

Gemäß einer weiteren bevorzugten Ausführungsform wird die LED bzw. werden die mehrere LEDs der Lichtquelle gepulst betrieben, wodurch eine Lichtintensität der LED mindestens um 30% größer ist als während eines Dauerbetriebs. Das Verhältnis der On/Off Time (Duty Cycle) der Pulsweitenregelung kann hierbei größer 25 % gewählt werden. Bei LED Quellen mit geringen Ladekapazitäten und schnellen Anstiegszeiten kann der Pulsbetrieb mit Pulsspitzen im Nanosekundenbereich durchgeführt werden. In der Anwendung nach Fig. 14 kann somit ein LED Array zur Vaporisierung von Werkstoffen mit vorzugsweise geringen Ablationsschwellen angewandt werden.

Vorzugsweise wird das Substrat, aus dem nach Belichtungs-, Entwicklungs- und Ätzverarbeitungsschritten eine Leiterplatte hergestellt wird, von einer Aufnahme aufgenommen. Die Aufnahme kann Einrichtungen aufweisen zur temporären Fixierung des Substrats, wie Klammern oder Verspannvorrichtungen. Alternative oder zusätzlich kann die Aufnahme eine Unterdruckeinrichtung aufweisen, wodurch das Substrat an die Aufnahme angesaugt wird. Beispielsweise kann die Aufnahme mehrere Ansauglöcher aufweisen, wobei die Unterdruckeinrichtung automatisch die Löcher erkennt, mit denen das Substrat angesaugt wird. Mit anderen Worten, die restlichen Löcher die nicht zum temporären fixieren des Substrats dienen werden nicht auf Unterdruck gesetzt.

Vorzugsweise ist die Aufnahme mit dem Substrat ortsfest bzw. stationär angeordnet und die Belichtungseinrichtung wird während der Belichtung bewegt. Es ist jedoch auch möglich, dass die Belichtungseinrichtung ortsfest bzw. stationär angeordnet ist und das Substrat während der Belichtung bewegt wird. Dies kann beispielsweise durch eine bewegbare Aufnahme erreicht werden. Zudem ist eine Kombination beider Bewegungen möglich, d.h., sowohl die Aufnahme als auch die Belichtungseinrichtung sind bewegbar. Auch ist es denkbar, dass die Belichtungseinrichtung während der Belichtung bewegt wird, um das gewünschte Muster auf die lichtempfindliche Schicht zu belichten und die Aufnahme lediglich zwischen Belichtungsschritten bewegt wird, beispielsweise zum Zuführen eines neuen Substrats.

Erfindungsgemäß wird mit dem emittierten Licht der Belichtungseinrichtung nur ein kleiner Teil des Substrats belichtet, wenn das Substrat bezüglich der Belichtungseinrichtung stationär ist. Mit anderen Worten, im Gegensatz zu Masken-Belichtungsverfahren, bei dem das komplette Substrat gleichzeitig belichtet wird und das (Schalt-)Muster mittels Maske belichtet und übertragen wird, emittiert die erfindungsgemäße Belichtungseinheit einen Strahl mit geringer Ausdehnung. Somit erzeugt die erfindungsgemäße Belichtungseinrichtung auf dem Substrat einen Belichtungsfleck mit einer festgelegten Ausdehnung. Hierbei definiert die festgelegte Ausdehnung die Mindestbreite einer belichteten Leiterbahn. Breitere Leiterbahnen können beispielsweise durch mehrere im Wesentlichen parallel und nebeneinander belichtete Bahnen erreicht werden bzw. kann durch die Verschiebung entlang der Z-Achse die Brennpunktabbildung aufgeweitet werden wodurch der belichtete Bereich vergrößert wird. Durch die Relativbewegung während der Belichtung wird das gewünschte Muster bzw. die gewünschte Schaltungsstruktur, auf die lichtempfindliche Schicht des Substrats übertragen.

Die erfindungsgemäße Belichtungseinrichtung ist vorzugsweise relativ klein. Zudem weist die Belichtungseinrichtung ein distales Ende und ein proximales Ende auf, wobei die mindestens eine Leuchtdiode am distalen Ende angebracht wird, und das emittierte Licht vom distalen zum proximalen Ende der Belichtungseinrichtung gebündelt und/oder aufgeweitet wird, und schließlich die Belichtungseinrichtung am proximalen Ende als Strahl verlässt. Das proximale Ende der Belichtungseinrichtung wird nahe dem zu belichtenden Substrat angeordnet (daher die Bezeichnung proximales Ende). Mit anderen Worten, es ist bevorzugt, dass ein Lichtstahl mit geringer Ausdehnung das proximale Ende der Belichtungseinrichtung verlässt, so dass auf dem zu belichtenden Substrat, das nahe zum proximalen Ende angeordnet ist, ein Beleuchtungsfleck mit kleiner Ausdehnung erzeugt wird.

Vorzugsweise weist die erfindungsgemäße Lithografiebelichtungseinrichtung optische Mittel zur Bündelung bzw. Fokussierung des Lichtes auf, um einen Lichtstrahl mit geringer Strahlbreite bzw. Ausdehnung zu erzeugen. Beispiel kann eine Sammellinse zum Bündeln des von der Leuchtdiode emittierten Lichtes verwendet werden. Gemäß einer weiter bevorzugten Ausführungsform wird das Licht auf einen Brennpunkt fokussiert, wobei sich der Brennpunkt vorzugsweise in der Ebene des proximalen Endes der Belichtungseinrichtung befindet. Insbesondere ist es bevorzugt, dass die bestrahlte Fläche gegenüber den zu belichtenden Schaltungsplatten sehr klein ist, was im folgenden auch als punkförmig bezeichnet wird.

Zudem können die optischen Mittel einen Reflektorschirm aufweisen, um beispielsweise innerhalb der Belichtungseinrichtung paralleles Licht zu erzeugen und/oder eine Spiegelkammer aufweisen.

Die Belichtungseinrichtung weist eine Blende auf. Diese Blende ist vorzugsweise am proximalen Ende der Belichtungseinrichtung angeordnet, um die Ausdehnung des emittierten Lichtstrahls zu begrenzen. Gemäß einer weiter bevorzugten erfindungsgemäßen Ausführungsform befinden sich der Brennpunkt und die Blende in einer gemeinsamen Ebene, vorzugsweise am proximalen Ende der Belichtungseinrichtung. Mit einer derartigen Anordnung kann die Ausdehnung des emittierten Lichtstrahls über die maximal fokussierbare Auflösung hinaus begrenzt werden. Zudem können so Streuungseffekte vermindert oder eliminiert werden.

Die Belichtungseinrichtung weist eine Öffnung bzw. Aussparung auf, vorzugsweise am proximalen Ende. Gemäß einer weiteren Ausführungsform können verschiedene Blendenmasken, beispielsweise mit unterschiedlichen Blenden (Öffnungen) austauschbar eingesetzt werden. Die Blende ist variabel, vorzugsweise diskret oder kontinuierlich, verstellbar. Zudem kann die Blende entweder manuell und/oder automatisch, d.h. in Abhängigkeit eines Signals von einer Steuereinrichtung, die später detaillierter beschrieben wird, veränderbar sein. Bei Auflösungen der Linienbreiten unterhalb der möglichen Fokussierungsauflösungen ist es mit einer automatisch verstellbaren Blende möglich, während eines Belichtungsvorgangs die Auflösung noch weiter herabzusetzen auf Kosten der Verfahrgeschwindigkeit und Belichtungszeit. Um Leiterbahnen mit geringer Breite zu belichten, wird die Blende, beispielsweise in Abhängigkeit eines Steuersignals, verkleinert.

Die erfindungsgemäße Bewegungseinrichtung ist vorzugsweise angepasst, um eine Relativbewegung in zwei Dimensionen (X, Y), vorzugsweise parallel zum Substrat, zur ermöglichen. Eine solche Bewegung kann beispielsweise mit einer Zwei-Achsen-Positionierungsmechanik erreicht werden. Es ist bevorzugt, dass die Belichtungseinrichtung mit einem gleichbleibenden Abstand über dem Substrat bewegt wird. Die Belichtungseinrichtung ist vorzugsweise mit einem geringen Abstand zum zu belichtenden Substrat bewegbar, sodass der Abstand zwischen dem Punkt des austretenden Lichtes und des Substrats wenige mm beträgt, vorzugsweise weniger als 2 mm, weiter bevorzugt weniger als 1 mm.

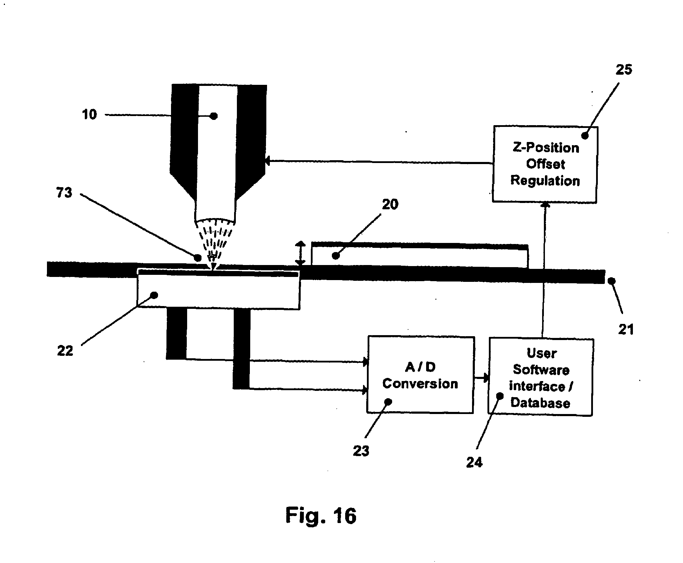

Gemäß einer weitem bevorzugten Ausführungsform kann die Bewegungseinrichtung auch angepasst sein, um eine Relativbewegung in drei Dimensionen (X, Y, Z), vorzugsweise parallel und senkrecht zum Substrat zu ermöglichen. Somit ist es möglich den Abstand in Z-Richtung zwischen der Belichtungseinrichtung und dem Substrat vor, während und/oder nach der Belichtung zu verändern. Vorzugsweise wird bei wechselnden Substrathöhen eine Neupositionierung der Belichtungseinrichtung entlang der Z-Achse durchgeführt (siehe beispielsweise Fig. 16). Die Neupositionierung wird beispielsweise zusammen mit einer Neukalibrierung der Belichtungseinheit erreicht, was beispielsweise über die Verstellung der Position des Fokuspunktes in der XY-Ebene (mittels Verschiebung der Belichtungseinrichtung entlang der Z-Achse) durchgeführt wird. Ebenso kann während des Belichtungsvorganges eine Verschiebung entlang der der Z-Achse die Belichtungseinheit aus dem Brennpunkt bewegen und somit eine Strahlaufweitung hervorrufen, um größere Flächen zu belichten.

Um möglichst kleine Strukturen bzw. Muster, beispielsweise für Mikroleiterbahnen, auf das Substrat zu belichten, ist neben einer Belichtungseinrichtung mit kleiner bzw. nahezu punktförmiger Belichtungsfläche eine exakte Relativbewegung der Bewegungseinrichtung besonders vorteilhaft. Vorzugsweise weist die Bewegungseinrichtung eine Positionsgenauigkeit von kleiner 1mm, vorzugsweise kleiner als 0,1 mm und weiter bevorzugt von kleiner als 0,05mm und noch weiter bevorzugt kleiner als 0,01 mm auf.

Gemäß einer weiter bevorzugten Ausführungsform weist die erfindungsgemäße Lithografiebelichtungseinrichtung mehrere Belichtungseinrichtungen auf. So kann beispielsweise eine einzelne Belichtungseinrichtung lösbar an einer Kupplung der Bewegungseinrichtung angebracht sein, wobei die restlichen Belichtungseinrichtungen für andere Belichtungsvorgänge bereitgestellt werden. Die Kopplung einer einzelnen Belichtungseinrichtung mit der Bewegungseinrichtung kann manuell geschehen, oder automatisch, vorzugsweise in Abhängigkeit eines Steuersignals von einer Steuereinrichtung.

Zudem kann die Kupplung der Bewegungseinrichtung angepasst sein, um beispielsweise einen Bohr- bzw. Durchkontaktier-Einrichtung, eine Kamera, wie beispielsweise eine CMOS Kamera oder andere Belichtungseinrichtungen (z.B. mit IR-Leuchtmittel) aufzunehmen.

Die erfindungsgemäße Belichtungseinrichtung weist mindestens eine UV-Leuchtdiode auf, die vorzugsweise Licht in einem Bereich von 350 - 405 nm, vorzugsweise mit einer Leistung von mindestens 100 mW/cm$^2$ emittiert. Zudem kann in einer Belichtungseinrichtung ein Leuchtmittel bereitgestellt werden, das Licht im Infrarot (IR) Bereich emittiert, vorzugsweise gebündelt.

Gemäß einer weiteren bevorzugten Ausführungsform kann eine Belichtungseinrichtung mehrere LEDs aufweisen. Vorzugsweise werden mehrere LEDs in Form einer Anordnung, eines Feldes bzw. einer Matrix angeordnet.

Gemäß einer weiteren bevorzugten Ausführungsform können die Leuchtdioden oder Gruppen der Anordnung individuell angesteuert werden, so dass die Leuchtdioden bzw. Gruppen einzeln an bzw. aus geschaltet werden können bzw. deren Intensität individuell oder in Gruppen gesteuert werden kann.

Gemäß einer weiteren bevorzugten Ausführungsform weist eine erfindungsgemäße Lithografiebelichtungseinrichtung eine Steuerung auf. Diese Steuerung kann beispielsweise die Relativbewegung und/oder die Intensität einzelner Leuchtdioden bzw. Leuchtdioden-Gruppen und/oder die Blendenöffnung und/oder die Bestückung einer an der Bewegungsreinrichtung vorhandenen Kupplung mit Belichtungseinrichtungen oder Bohr- bzw. Durchkontaktier-Einrichtung bzw. eine Kamera steuern.

Die Erfindung betrifft auch ein System zum Herstellen einer Leiterplatte. Diese System umfasst vorzugsweise eine Lithografiebelichtungseinrichtung zum Belichten eines Substrats mit lichtempfindlicher Schicht mittels UV-Leuchtdiode, vorzugsweise nach einer oben beschriebenen Ausführungsformen und nachgeschaltet eine Entwicklungs-Ätzvorrichtung zum Entwickeln und/oder Ätzen und/oder Spülen des mit der Lithografiebelichtungseinrichtung belichteten Substrats. Mit anderen Worten, mit dem erfindungsgemäßen System kann aus dem belichteten Substrat schließlich eine Leiterplatte hergestellt werden.

Zusätzlich kann das System auch eine Bohr- bzw. Durchkontaktier-Einrichtung zum Bohren bzw. Durchkontaktieren des Substrats vor und/oder nach der Belichtung aufweisen.

Um eine Belichtung der lichtempfindlichen Schicht mit Fremdlicht zu vermeiden, kann die erfindungsgemäße Lithografiebelichtungseinrichtung bzw. das erfindungsgemäße System eine Abschirmung aufweisen, die angepasst ist, dass das Substrat im Wesentlichen nur von der Belichtungseinrichtung belichtet wird.

Zudem betrifft die Erfindung auch ein Verfahren zum lithografischen Belichten eines Substrats mit einer lichtempfindlichen Schicht mit den Schritten: Bereitstellen einer Lithografiebelichtungseinrichtung mit mindestens einer UV-Leuchtdiode aufweisenden Belichtungseinrichtung, Anordnen des Substrats, beispielsweise in einer Aufnahme, sodass die lichtempfindliche Schicht mit dem von der Belichtungseinrichtung emittierten Licht belichtet werden kann, und Belichten des Substrats mit der Belichtungseinrichtung, wobei das Substrat relativ zur Belichtungseinrichtung während der Belichtung bewegt wird.

Gemäß einer weiteren bevorzugten Ausführungsform kann die Intensität des emittierten Lichtes während der Belichtung verändert werden.

Gemäß einer weiteren bevorzugten Ausführungsform kann die Bündelung des emittierten Lichtes während der Belichtung verändert werden, beispielsweise mittels einer veränderbaren Blende.

Gemäß einer weiteren bevorzugten Ausführungsform kann die Bewegungseinrichtung zudem mit einem Bohrer bzw. Fräser versehen werden, um vor bzw. nach dem Belichten Löcher bzw. Aussparungen in das Substrat zu Bohren bzw. zu Fräsen. So kann beispielsweise vor/nach dem Belichtungsschritt die Belichtungseinrichtung durch eine Bohr- bzw. Durchkontaktier-Einrichtung ausgetauscht werden, um in einem vorherigen/nachfolgenden Schritt das belichtete Substrat zu Bohren bzw. Durchzukontaktieren.

Gemäß einer weiteren bevorzugten Ausführungsform kann in nachfolgenden Arbeitschritten eine Leiterplatte durch Entwicklungs-, Spühl- und Ätzschritte hergestellt werden.

Die erfindungsgemäße Lithographielichtungseinrichtung (bzw. der erfindungsgemäße UV-LED Plotter) stellt eine neue Möglichkeit zur Optimierung heutiger Lithographieverfahren dar. Durch die Anwendung von linsengebündeltem UV-Licht einer oder mehrerer LED-Quellen und die mechanisch geregelte Positionierung des emittierten Lichtstrahls, kann eine punktgenauere, energie- und materialsparsamere Belichtung die heutige Technik der Maskenlithographie in der Klein- und Mittelserienproduktion sowie im Rapid Prototyping ablösen.

Die erfindungsgemäße Lithographiebelichtungseinrichtung verwendet vorzugsweise Hochleistungsleuchtdioden mit optischen Mitteln, insbesondere Linsensystemen, die eine gleichverteilte, stark gebündelte Intensitätsdichte auf geringstem Raum schaffen. Vorzugsweise werden LEDs verwendet, die Licht im Bereich von 350 - 405 nm, vorzugsweise mit einer optischen Lichtleistungen von mindestens 100 mW/cm$^2$ pro LED-Quelle emittieren. Vorzugsweise umfasst die erfindungsgemäße Lithographiebelichtungseinrichtung LEDs mit einer mittlere Wellenlänge von ca. 405 nm, wobei die LEDs zudem Nebenkeulen mit einer Toleranz von $\pm$ 5 nm aufweisen können. Somit ist das Emissionsspektrum einer bevorzugten LED rein Ultra-Violett, d.h der komplette Wellenlängenbereich des emittierte Licht wird zur Belichtung des Fotoresist (empfindlich hauptsächlich im Wellenlängenbereich 350 nm - 450 nm) effektiv genutzt.

Vorzugsweise wird in der erfindungsgemäßen Belichtungseinrichtung das von der LED emittierte Licht mittels optischer Mittel, zunächst durch eine erste Linsenstufe maximal kollimiert und in einer Zwischenebene abgebildet. Vorzugsweise kann dies durch mehrere gruppierte Linsensysteme erfolgen. Eine nachgeschaltete, vorzugsweise geometrisch geringe optische Einheit bildet diese Projektion in der Zwischenebene maximal fokussiert auf dem Trägersubstrat ab, d.h. mittels Strahlbündelung kann die volle Leistung der LED auf einen Bereich von wenigen mm2 bzw. $\mu$m2 zentriert werden. Zudem oder alternativ kann der Strahldurchmesser des von der erfindungsgemäßen Belichtungseinrichtung emittierten Lichtes beispielsweise mechanisch und/oder elektro-mechanisch geregelt werden. Beispielsweise kann durch die Verwendung einer optischen Irisblende die Strahlöffnung und somit der Stahldurchmesser über die maximale Fokussierung der Linseneinheiten hinaus kontinuierlich für noch geringere Auflösung variiert werden. Gemäß einer weiteren bevorzugten Ausführungsform können unterschiedliche Belichtungseinrichtungen bereitgestellt werden, die von der Bewegungseinrichtung bewegt werden. Es können mehrere Belichtungseinrichtungen bereitgestellt werden, die sich bezüglich der emittierten Strahlungsleistung, bezüglich der Stahlbreite und/oder der Wellenlänge unterscheiden können.

Anstelle verschiedene Belichtungseinrichtungen bereitzustellen, können auch verschiedene Blenden bereitgestellt werden, die je nach Bedarf an eine Belichtungseinreichung angebracht werden, um den Strahldurchmesser zu verändern bzw. zu variieren. Es ist auch möglich verschiedene Belichtungseinrichtungen und verschiedene Blenden zum Austausch bereitzustellen.

Erfindungsgemäß beträgt der Abstand zwischen der Belichtungseinrichtung und dem Substrat wenige mm, so dass auch bei dem Anwendungsfall mit proximal zugeschalteter Blende für Auflösungen oberhalb der maximalen Fokussierung vorzugsweise keine signifikanten Beugungsmuster entstehen. Im Folgenden wird die erfindungsgemäßen Lithografiebelichtungseinrichtung mit einem Maskenlithographiegerät und einem Laserlithographen aus dem Stand der Technik verglichen (siehe nachfolgende Tabelle).

| | Lithographie Gerät | | |
| --- | --- | --- | --- |
| | **UV-LED-Plotter/ Lithografiebelichtungseinrichtung** | **Maskenlithograph** | **Laserlithograph** |
| Genauigkeit der Leiterbahnstärke | ca. 0,1 mm | > 0,3 mm* | >1$\mu$m |
| Genauigkeit der Leiterbahnabstände: | ca. 0,1 mm | > 0,1 mm* | > 80 $\mu$m |
| Ausleuchtung der Leiterbahnen im Bezug zur gesamten Lichtleistung pro cm$^2$: | 100 % | ca. 0,01 % | 100 % |
| Erforderliche Zusatzgeräte bzw. Material ausschließlich Leierplattenmaterial | keine | Drucker, Folienmaterial, Schneidegerät Folie, Folienhalter, Folienkleber | keine |
| Fotolackbeschichtung: | Negativ | Positiv | Negativ |
| Energieverbrauch: | ca. 8 W | 8000 W 2 x Röhren | typischerweise > 1 kW |

| | Lithographie Gerät | | |
| --- | --- | --- | --- |
| | **UV-LED-Plotter/ Lithografiebelichtungseinrichtung** | **Maskenlithograph** | **Laserlithograph** |
| Zusätzliche Arbeitsschritte: | keine | Drucken beider Layouts, Zuschnitt Folie, Präzises Ausrichten beider Layouts, Folien verkleben, Leiterplatte ausrichten, anpressen | keine |
| Fachpersonal zur Bedienung nötig: | Nein | Ja | Ja |
| Ausschuss bzw. Fehlerrate durch Überbelichtung: | < 0,1 % | ca. 10 % | < 0,1 % |
| Bedienung des Gerätes: | Von jedem PC aus möglich, | Nur manuell möglich, Standortabhängig | k.A. |
| Haltbarkeit bzw. Langlebigkeit: | Möglicher Verschleiß der Mechanik nach Jahrzehnten | Mindestens halbjähriges Wechseln der UV-Röhren | Möglicher Verschleiß der Mechanik nach Jahrzehnten, sämtliche Laserreparaturen sehr kostenintensiv |
| Schnelligkeit der Belichtung pro Platine: | Ca. 2 min | Ca. 30 s | typischerweise einige Minuten bis Stunden |

Einige weitere Vorteile des UV-LED-Plotters, welche sich tabellarisch nicht so einfach gegenüberstellen lassen, sind unter anderem der Größenunterschied aufgrund der unterschiedlichen Lichtquellen, geringere Umweltverschmutzung durch neue effizientere Energienutzung und Vermeidung von Zusatz -und Abfallmaterial sowie die damit verbundenen günstigeren Produktionskosten.

Der Anwender kann somit schneller, präziser, in weniger Arbeitsschritten, mit weniger Material und günstigeren Betriebsmitteln (z.B. Strom), ohne Fachpersonal, ohne zusätzliche Geräte, Standort unabhängig und mit geringeren Anschaffungskosten einseitig und beidseitige beschichtete Kupferplatinen herstellen wie bisher.

Die Standortunabhängigkeit kann durch eine Anbindung der Lithografiebelichtungseinrichtung an eine Ethernet-Schnittstelle gewährleistet werden. Die Lithografiebelichtungseinrichtung fungiert gewissermaßen als Netzwerkdrucker innerhalb eines LAN (Lokales Netzwerk) und ist somit von jedem Client dieses Netzwerkes ansprechbar. Gleichzeitig oder alternativ kann eine lokale Anbindung des UV-LED-Plotters per USB-Bus an jede portable Docking-Station wie z.B. einem Laptop stattfinden. Auch ein integrierter SD-Kartenleser kann eingebunden werden. Platinenlayouts können somit jederzeit geräteunabhängig der Belichtungseinrichtung zugeführt werden.

Mit anderen Worten, die vorliegende Erfindung betrifft unter anderem eine vorzugsweise annähernd punktförmige, direkte Mikrobelichtung eines mit Fotolack beschichteten Substrates mittels einer UV-Licht emittierenden Lumineszenzdiode, insbesondere in Kombination mit ein- bzw. mehrstufigen Fokussierungssystemen mit speziellen Linsenmaterialien mit Transmissionsanteilen im Wellenlängenbereich zwischen 350nm und 405nm von mindestens 90 % (z.B. BK7, SF10 etc.), vorzugsweise im Wellenlängenbereich zwischen 350-1000nm von mindestens 90% bzw. eine direkte Strukturierung von Leiterzügen des Schaltungsträgers ohne zusätzliches Maskenmaterial.

Auch betrifft die Erfindung eine UV-LED Belichtungseinheit, deren schrittweise verlustarme Bündelung bzw. Fokussierung durch eine zwei- bzw. mehrstufige bis zu dreistellige Verkleinerung des Halbwertswinkels ($\alpha'/\beta'$) der Quelle durch ein Primärlinsensystem erreicht wird, in Kombination mit einer nachgeschalteten fokussierenden Einheit, vorzugsweise mit achromatischen Eigenschaften.

Erfindungsgemäß wird auch eine UV-LED Belichtungseinheit bereitgestellt, deren Fokussierung über ein aplanatisches, asphärisches Kondensorlinsensystem mit maximal geringen Brennweiten erfolgt. Hierbei wird der Fokussierungskegel durch variable Spalt- bzw. Lochblenden gegen inkohärente Abbildungsfehler begrenzt.

Eine weitere Ausführungsform der vorliegenden Erfindung betrifft eine UV-LED Belichtungseinheit, bestehend aus einem auf einem Chip geometrisch angeordneten Array oder einer Anordnung von verschiedenen einzelnen LED-Quellen auf einem Materialträger, parallelisiert durch ein Mikrolinsenarray oder einer Flächenanordnung von konvexen Linsen in einer Ebene im Halbwertswinkel minimiert und Brennpunkt fokussiert.

Ein weiteres erfindungsgemäßes Verfahren umfasst die Schritte: Positionierung der Belichtungseinheit über ein zweiachsigen Linear- bzw. Schrittantrieb, Zeilenförmiger Belichtungsprozess durch kontinuierlichen Vorschub einer Achse, Aufbau des Leiterbildes zeilenförmig.

Ein weiteres erfindungsgemäßes Verfahren umfasst die Schritte: Positionierung der Belichtungseinheit über ein dreiachsigen Linear- bzw. Schrittantrieb, zellenförmiger Belichtungsprozess durch kontinuierlichen Vorschub entlang einer Achse, Aufbau des Leiterbildes zeilenförmig, wobei die Zeilenbreite durch Verschiebung entlang der Z-Achse und somit der Quelle aus dem Brennpunkt variiert werden kann. Dadurch kann eine größere (breitere) Zeilenbelichtung erfolgen, z.B. bei Masseflächen; der Vorschub gewissermaßen teilweise nicht kontinuierlich.

Ein weiteres erfindungsgemäßes Verfahren umfasst die Schritte: Positionierung der Belichtungseinheit über einen Kleinroboter bzw. Roboterarm, gesteuert über Kugelkoordinaten z.B. für die Strukturierung von dreidimensionalen Materialien oder Schaltungsträgern.

Ein erfindungsgemäßes Verfahren ermöglicht auch das gleichzeitige Belichten doppelseitiger Schaltungsträger durch zweiseitige Belichtung mittels zweier Belichtungseinrichtungen auf Vorder- und Rückseite mit vorzugsweise individuellen Vorschubgeschwindigkeiten.

Die (Fein)justierung des Brennpunktes kann erfindungsgemäß durch Anordnung einer wellenlängenabhängigen Photodiode auf Höhe des Arbeitsbereiches, mittels A/D-Software-Schwellwert-Detektion und Offsetregulierung durchgeführt werden. Durch eine darauf folgende Usereingabe der Substrathöhe und Aufkupferung des Materials innerhalb einer Softwareumgebung wird die Regulierung der Z-Achse vor Belichtungsbeginn auf das jeweilig zu belichtende Substrat stattfinden.

Eine weitere erfindungsgemäße Lithographiebelichtungseinrichtung ermöglicht auch die Stabilisierung des Trägersubstrates über eine Rahmenkonstruktion, wobei die Rahmenkonstruktion abhängig von den Substrateigenschaften manuell gewechselt werden kann, und das rechteckige Substrat an zwei fixen Gehäusekanten verklemmt werden kann. Mit Hilfe einer variablen eingeschobenen Achse, magnetischen oder mechanische Einrastung an Rändern der Arbeitsfläche oder durch magnetische Ansaugung durch Bodenbelag oder Pass-Stifte-Systeme kann das Substrat fixiert werden.

Schließlich umfasst ein erfindungsgemäßer dreistufiger Fertigungsprozess vorzugsweise die Schritte: (a) Belichtung einer Teilschaltungen auf einer Nutzfläche durch eine erfindungsgemäße Belichtungseinrichtung; (b) Isolationsbelichtung durch Belichtung eines Rahmens um die Teilschaltungen; (c) Entwicklung, Ätzung der gesamten Nutzfläche und (d) Nutzen Trennung durch schichtweise Vaporisierung des Restsubstrates entlang des Rahmens unter Verwendung einer erfindungsgemäßen Belichtungseinheit oder unter Verwendung einer IR-Laserdiode.

## Kurze Beschreibung der Zeichnungen

Im Folgenden werden bevorzugte Ausführungsformen der vorliegenden Erfindung unter Bezugnahme auf die Figuren ausführlich beschrieben. Es zeigen:

Fig. 1        eine perspektivische Ansicht einer erfindungsgemäßen Lithographiebelichtungseinrichtung in Form eines XY-Plotters mit einer Belichtungseinrichtung;

Fig. 2        eine perspektivische Ansicht einer erfindungsgemäßen Belichtungseinrichtung;

Fig. 3        eine perspektivische Ansicht einer Bohreinrichtung die anstelle der Belichtungseinrichtung an dem XY-Plotter angebracht ist,

Fig. 4        eine geschnittene Ansicht der in Figur 2 dargestellten Belichtungseinrichtung;

Fig. 5        eine weitere geschnittene Ansicht der in Figur 4 dargestellten Belichtungseinrichtung;

Fig. 6        eine Anordnung mit mehreren LEDs die in einer weiteren Ausführungsform der erfindungsgemäßen Belichtungseinrichtung eingebaut ist;

Fig. 7    eine schematische Darstellung einer Anordnung mit mehreren LEDs mit unterschiedlicher Intensität, ähnlich der in Figur 6 dargestellten Anordnung;

Fig. 8    ein Flussdiagramm zur Darstellung des erfindungsgemäßen Belichtungsverfahrens mit anschließenden Verarbeitungsschritten in einem erfindungsgemäßen System;

Fig. 9    eine schematische Ansicht einer Belichtungseinrichtung in der die stufenweise Kollimierung und Zwischenabbildung sowie die nachgeschaltete fokussierte Abbildung mithilfe des Strahlenverlauf des emittierten Lichtes schematisch dargestellt ist;

Fig. 10-12    weitere schematische Ansichten Belichtungseinrichtungen in der der Strahlenverlauf des emittierten Lichtes schematisch dargestellt ist;

Fig. 13    eine schematische Ansicht einer weiteren erfindungsgemäßen Belichtungseinrichtung mit Kondensorlinsensystem;

Fig. 14    eine weitere schematische Ansicht einer Belichtungseinrichtung mit mehreren LEDs die in einem Array oder einer Matrix über zwei Dimensionen über eine Fläche verteilt angeordnet sind (ähnlich wie in Fig. 6 dargestellt), wobei das von den LEDs emittierte Licht mittels einem mehrstufigen Linsensystem auf dem Substrat abgebildet wird;

Fig. 15    eine Ausführungsform einer erfindungsgemäßen Lithographiebelichtungseinrichtung zum gleichzeitigen Belichten eines doppelseitig beschichteten Substrats;

Fig. 16    eine Ausführungsform einer erfindungsgemäßen Lithographiebelichtungseinrichtung mit einer Einrichtung zur Feinjustage des Abstands zwischen Belichtungseinrichtung und Substrat bzw. der Kalibrierung der Belichtungseinheit vor Belichtungsbeginn;

Fig. 17    eine perspektivische Ansicht einer erfindungsgemäßen Lithographiebelichtungseinrichtung mit einer beweglichen Belichtungseinrichtung beim Belichtungsvorgang bzw. Strukturierungsvorgang eines mit Fotolack überzogenen Substrates;

Fig. 18    eine perspektivische Ansicht eines mit einer Isolations-Struktur belichteten Substrats nach dem Entwicklungs- und Ätzprozess;

Fig. 19    eine perspektivische Ansicht einer erfindungsgemäßen Lithographiebelichtungseinrichtung wie in Fig. 17 mit einem bearbeiteten Substrat wie in Fig.18 bei der Trennung der Teilschaltung aus einem gesamten Nutzen durch die Belichtungseinheit;

Fig. 20    eine perspektivische Ansicht einer erfindungsgemäßen Lithographiebelichtungseinrichtung;

Fig. 21    eine perspektivische Ansicht der erfindungsgemäßen Lithographiebelichtungseinrichtung aus Figur 20 jedoch mit fixiertem Substrat; und

Fig. 22    eine halbdurchsichtige perspektivische Ansicht einer Belichtungseinrichtung.

**Detaillierte Beschreibung bevorzugter Ausführungsformen**

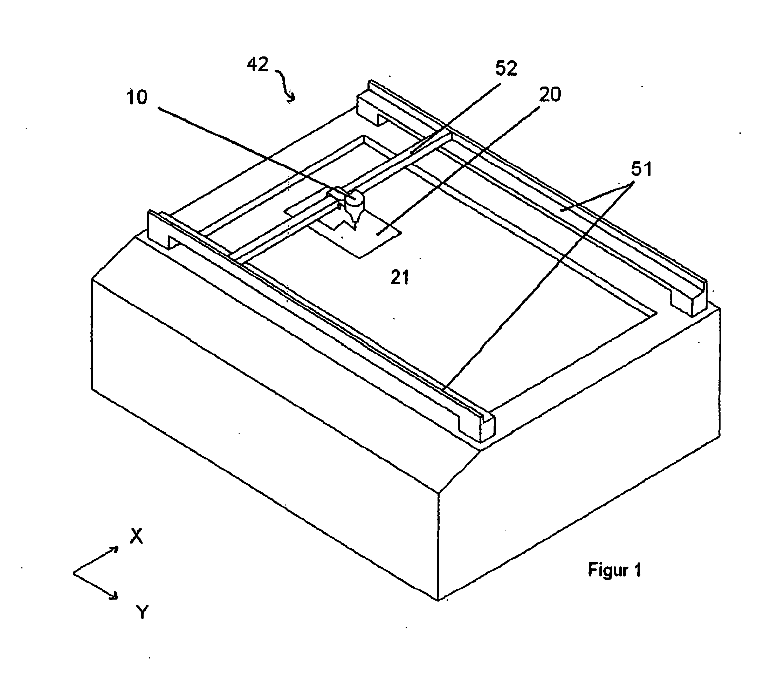

Figur 1 zeigt eine perspektivische Ansicht einer erfindungsgemäßen Lithografiebelichtungseinrichtung 42 in Form eines XY-Plotters. Der dargestellte XY-Plotter weist zwei seitliche Führungsschienen 51 auf, um eine Bewegung in der Y-Richtung zu ermöglichen, sowie eine Schiene 52, die von den beiden seitlichen Schienen 51 geführt wird, um eine Bewegung entlang der X-Achse der Belichtungseinrichtung 10 zu ermöglichen. Diese Schienen stellen somit die Bewegungseinrichtung, bzw. einen Teil davon dar. Zudem umfasst der XY-Plotter eine Fläche bzw. Aufnahme 21 zum Aufnehmen eines zu belichtenden Substrats 20. Bei dieser erfindungsgemäßen Ausführungsform wird das Substrat 20 in der Aufnahme 21 ortsfest angebracht. Die Bewegungseinrichtung bewegt die Belichtungseinrichtung 10 in X- bzw. in Y-Richtung während der Belichtung. Zudem kann eine Bewegung der Belichtungseinrichtung 10 in die Z-Richtung möglich sein, um beispielsweise die Bündelungseigenschaften bzw. die Abbildungseigenschaften des Lichtstrahls auf dem Substrat 20 zu verändern. Erfindungsgemäß können jedoch auch Belichtungseinrichtungen bereitgestellt werden, deren Abbildungseigenschaften im Wesentlichen unverändert bleiben, wenn die Belichtungseinrichtung um einige mm bzw. cm in der Z-Richtung verschoben wird. So ist es beispielsweise vorteilhaft, die Belichtungseinrichtung 10 in der Z-Richtung zu verschieben in Abhängigkeit von unterschiedlichen Dicken von Substraten 20. Zudem kann eine Bewegung in Z-Richtung die Fokussierungsjustage der Belichtungseinrichtung 10 erleichtern.

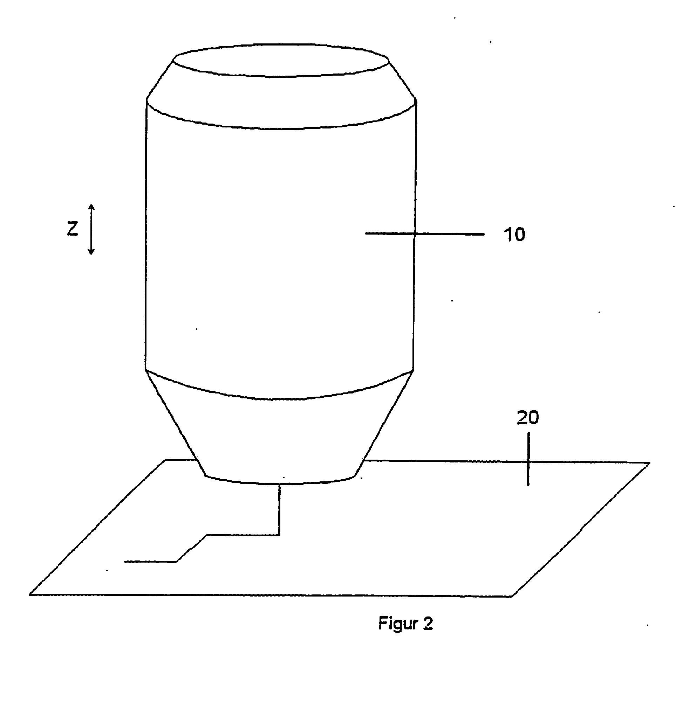

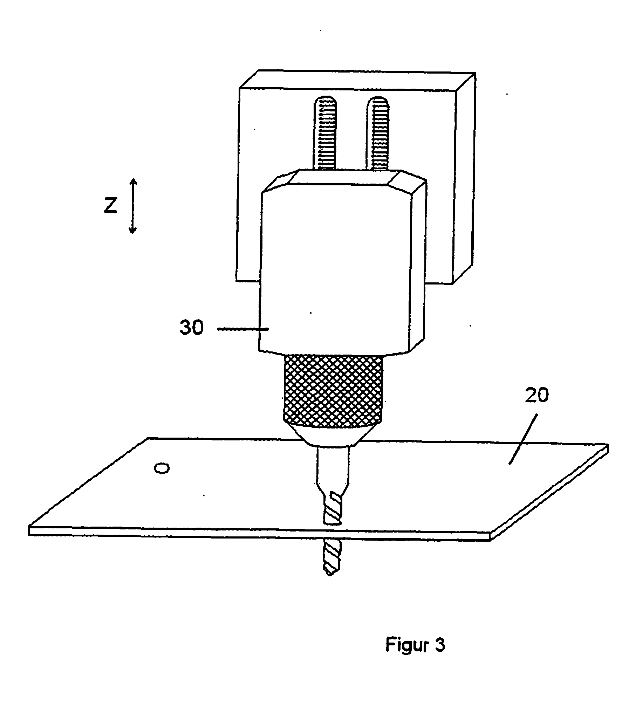

Figur 2 zeigt eine erfindungsgemäße Belichtungseinrichtung 10 in einer seitlichen perspektivischen Ansicht. Die Koordinatenachse "Z" auf der linken Seite deutet an, dass die Belichtungseinrichtung 10 in bevorzugten Ausführungsformen entlang dieser Z-Achse bewegbar ist. Zudem ist schematisch ein von der Belichtungseinrichtung 10 emittierter Lichtstrahl dargestellt, der das darunter liegende Substrat 20 mit einem dünn gebündelten Lichtstrahl belichtet. Aufgrund der Relativbewegung der Belichtungseinrichtung relativ zum Substrat während der Belichtung kann ein Muster, beispielsweise ein Schaltungsmuster, auf das Substrat 20 belichtet werden. Die auf dem Substrat 2 dargestellte "Belichtungsspur" dient nur zur schematischen Illustration, da sich der Fotolack bzw. die lichtempfindliche Schicht bzw. der Fotoresist üblicherweise nicht sofort nach der Belichtung sichtbar verändert, d.h. üblicherweise ist das Schaltungsmuster auf dem Fotoresist nach der Belichtung nicht zu sehen und tritt erst nach einem Entwicklungsschritt hervor. Wie bereits in der Einleitung der vorliegenden Anmeldung diskutiert, kann zur Herstellung einer Leiterplatte aus einem Substrat das Substrat entweder vor oder nach einer Belichtung durchkontaktiert bzw. gebohrt werden. Die exakte Positionierbarkeit mit Hilfe des erfindungsgemäßen XY-Plotters kann neben der exakten Belichtung auch dazu verwendet werden, eine Bohr- bzw. Durchkontaktiereinrichtung 31 exakt an die gewünschte Position zu bewegen. So zeigt Figur 3 beispielsweise eine Durchkontaktiervorrichtung 30 die zum Durchbohren des Substrats 20 entlang der Z-Richtung verschoben werden kann. Eine derartige Bohrvorrichtung kann entweder durch eine eigens für die Bohrvorrichtung vorgesehene Bewegungseinrichtung bereitgestellt werden, oder es kann eine gemeinsame Bewegungseinrichtung für die Bohr- und Belichtungseinrichtung mit einer Kupplung versehen sein, wobei diese Kupplung entweder mit einer erfindungsgemäßen Belichtungseinrichtung oder eine Bohreinrichtung gekoppelt werden kann. Die erfindungsgemäße Lithografiebelichtungseinrichtung kann ein Magazin bereitstellen, in dem beispielsweise mehrere Belichtungseinrichtungen 10 und mehrere Bohr- bzw. Durchkontaktiereinrichtungen 30 bereitgestellt werden, die je nach Wunsch an die Bewegungseinrichtung gekoppelt werden. Beispielsweise können Belichtungseinrichtungen 10 bereitgestellt werden, die eine unterschiedliche Strahlbreite aufweisen, so dass beispielsweise feine dünne Leiterbahnen mit einer Belichtungseinrichtung 10 mit extrem gebündeltem Strahl belichtet werden, wohingegen breitere Leiterbahnen, wie sie beispielsweise zur Verbindung mit Netzteilen benötigt werden, mit einer Belichtungseinrichtung belichtet werden können, die einen breiteren Lichtstrahl emittiert. Entsprechend können Bohreinrichtungen bereitgestellt werden mit unterschiedlichen Bohrergrößen, wodurch kleine bzw. große Löcher in das Substrat 20 gebohrt werden können.

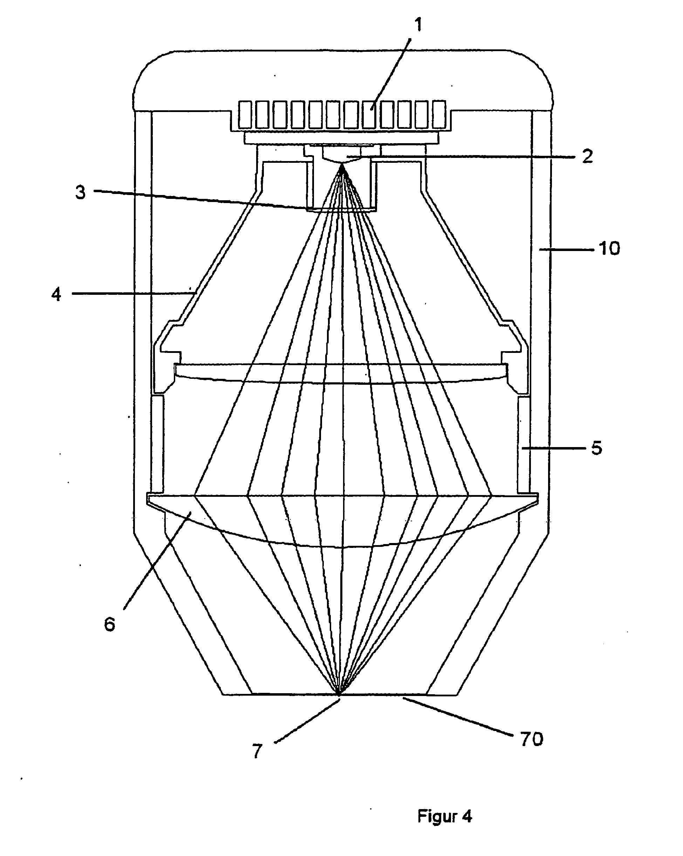

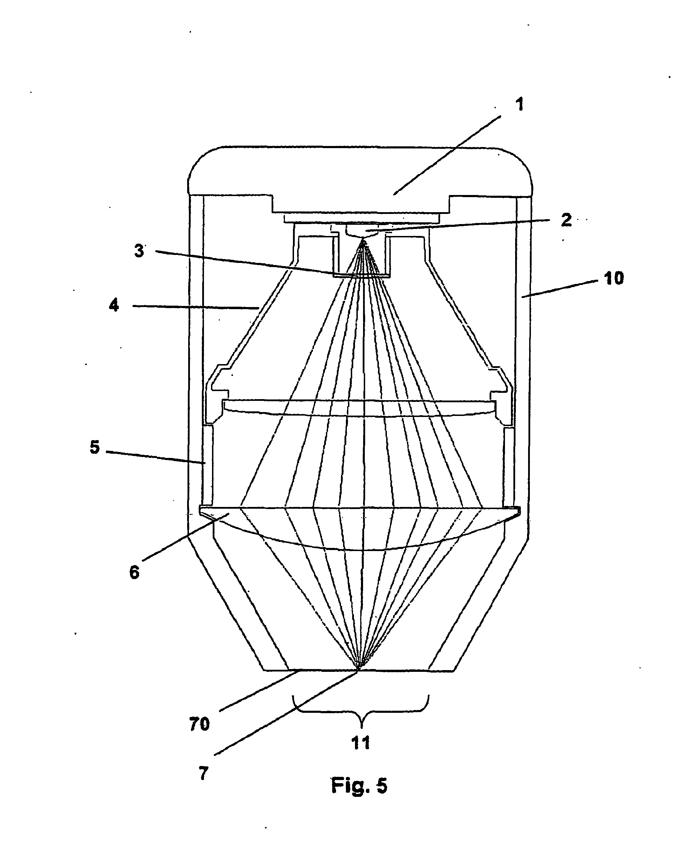

Die Figuren 4 und 5 zeigen eine geschnittene Ansicht der in Figur 2 dargestellten erfindungsgemäßen Belichtungseinrichtung 10. Am oberen bzw. distalen Ende der Belichtungseinrichtung 10 ist in der dargestellten Ausführungsform eine UV-LED 2 angeordnet. Bei dieser Leuchtdiode handelt es sich um eine Hochleistungs-UV-LED, die neben einer hohen Lichtintensität im UV-Bereich auch noch Wärme erzeugen kann, die mittels Heatsink bzw. Kühlkörper 1 abgeführt wird, um die Lebensdauer der Leuchtdiode 2 zu erhöhen. Das von der Leuchtdiode emittierte Licht wird mit Hilfe optischer Mittel 3, 4, 5 und 6 entlang der Belichtungseinrichtung 10 so verändert, dass das emittierte Licht vorzugsweise am proximalen Ende der Belichtungseinrichtung 10 auf einem Brennpunkt gebündelt wird. In der dargestellten Ausführungsform wird das direkt von der Leuchtdiode 2 emittierte Licht durch eine erste Linse 3 emittiert und über den Reflektor 4 in Richtung proximales Ende reflektiert. Etwaige Streustrahlung wird über die Spiegelkammer 5 weitergeleitet und schließlich wird das emittierte Licht mittels Sammellinse 6 auf einen Brennpunkt gebündelt. Vorzugsweise wird eine Blendenschablone 70 am proximalen Ende der Belichtungseinrichtung 10 bereitgestellt, wobei sich die Blendenöffnung 7 und der Brennpunkt des gebündelten Lichtes vorzugsweise im Wesentlichen in einer gemeinen Ebene befinden. Mit einer derartigen Konstruktion, d.h. mit einer Anordnung einer Blende um einen Brennpunkt, können Streulichter bzw. Streustrahlung effektiv ausgeblendet werden und zudem Beugungsmuster reduziert oder vollständig verhindert werden. Mit anderen Worten, das aus der Blende 7 emittierte Licht wird in Form eines extrem gebündelten Lichtstrahls emittiert, wodurch es möglich ist, auch extrem feine Leiterstrukturen auf einem Substrat zu belichten. Ähnlich wie bei einer Laserbelichtungsvorrichtung bei der ein extrem gebündelter Strahl mit Hilfe eines Lasers bereitgestellt wird, bietet die Belichtungseinrichtung der vorliegenden Erfindung dieselben Vorteile, d.h. einen extrem gebündelter Strahl. Jedoch ist die erfindungsgemäße Konstruktion mittels LED als Lichtquelle deutlich preiswerter als Ausführungsformen mit Laserlichtquellen. Zudem können unterschiedliche optische Mittel in der Belichtungseinrichtung 10 vorgesehen werden, um den Brennpunkt innerhalb der Belichtungseinrichtung oder außerhalb der Belichtungseinrichtung zu erzeugen, was für gewissen Anwendungen wünschenswert sein kann. Auch können unterschiedliche Blenden 7 bereitgestellt werden, wodurch eine Aufweitung der Bündelung erreicht werden kann, was beispielsweise für die Belichtung von breiteren Leiterbahnen bevorzugt sein kann. Die Blendenöffnung ist variabel ausgeführt, beispielsweise in Form einer Irisblende. Eine derartige Irisblende kann manuell verändert werden oder automatisch, ähnlich wie in einem Objektiv eines Foto-Objektives. Die Konstruktion mit einer LED als Belichtungsquelle bietet somit eine preiswerte Belichtungseinrichtung, die zudem mit einfachen Mitteln die Breite des Belichtungsstrahls verändern kann. Im Gegensatz dazu sind bei vergleichbaren Laserlitografiebelichtungseinrichtungen komplizierte optische Konstruktionen nötig, um den extrem gebündelten Laserstrahl zu verändern.

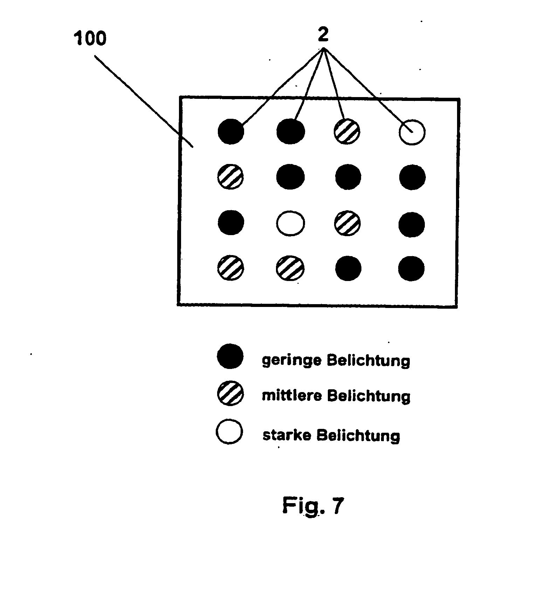

Die Figuren 6 und 7 zeigen weitere bevorzugte Ausführungsformen für die Leuchtmittel. Anstelle einer einzigen UV-Licht emittierenden Leuchtdiode können auch mehrere Leuchtdioden 2 in einer Anordnung angeordnet werden. So zeigt die Figur 6 beispielsweise eine Anordnung mit 16 Leuchtdioden, die auf einer Platte 101 angebracht sind. Die in einer 4x4 Matrix angeordneten Leuchtdioden sind über eine Steuereinrichtung vorzugsweise einzeln ansteuerbar, d.h. die Intensität jeder einzelnen Leuchtdiode kann individuell angepasst werden. Eine derartige Matrixanordnung hat den Vorteil, dass die Intensität des emittierten Lichtes über einen weiten Bereich variiert werden kann. Zudem kann eine bestimmte Anordnung in Matrixform auch die Breite des emittierten Lichtstrahls beeinflussen, was beispielsweise für die Belichtung unterschiedlich breiter Leiterbahnen bevorzugt sein kann. Figur 7 zeigt eine LED-Anordnung mit drei unterschiedlichen Belichtungsstärken. Die Ansteuerung der einzelnen LEDs bzw. Gruppen von LEDs mit unterschiedlicher Intensität erfolgt vorzugsweise rechnergestützt. So kann beispielsweise durch symmetrisch angeordnete Lichtquellen Information aufgrund der Musterform und der Intensitätswerte der einzelnen Punkte auf Mikrochips übertragen werden. Eine derartige Belichtungsvorrichtung kann somit neben der vorteilhaften Belichtung von Leitungsplatten auch für andere Bereiche angewendet werden, beispielsweise im Bereich von Biochips , Sicherheitstechnik, sowie Datenspeicherung, etc. Durch passende Positionierung der LED-Quelle und Anwendung des Bündelungsverfahrens können geometrische Formen in die Miniaturisierung übertragen werden und somit auch im Spezialfall eingesetzt werden. Prinzipiell sind zwei Verfahren möglich. Man könnte mit dem ersten Blendensystem das Muster für jeden Punkt abfahren und dementsprechend länger oder kürzer belichten. Somit ist die Auflösung nur noch linsenabhängig und nicht mehr strukturabhängig. Es wird nur noch eine LED benötigt. Jedoch könnte das zweite Verfahren schneller gehen.

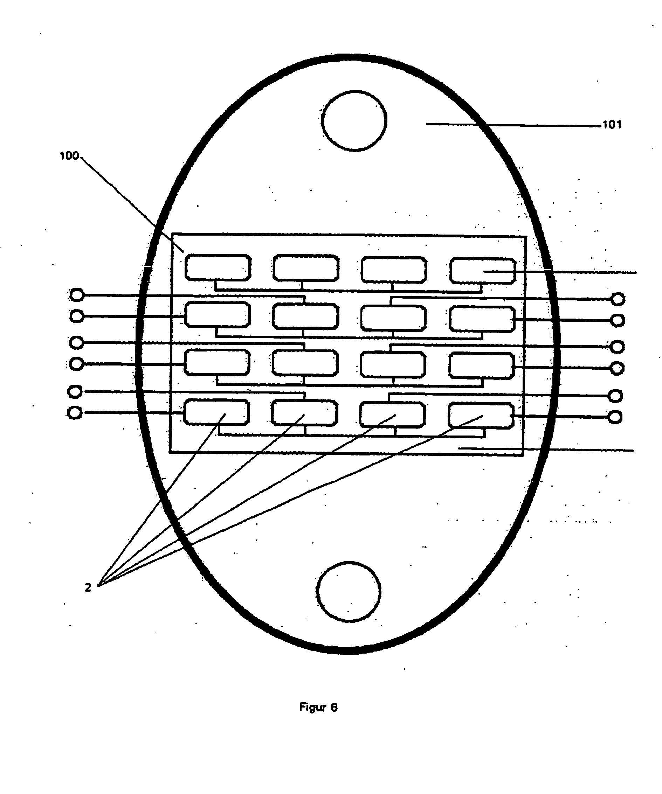

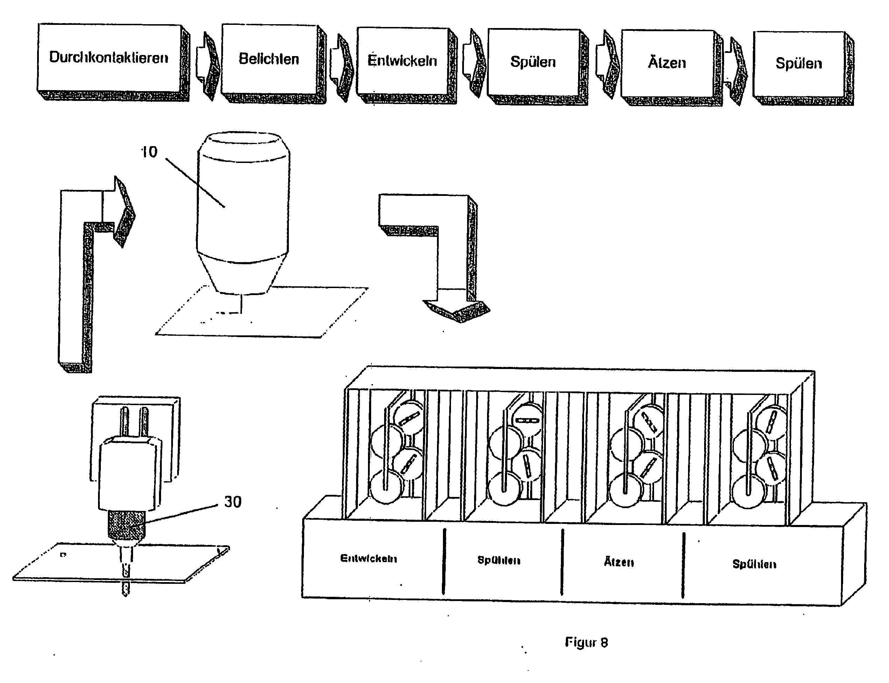

Schließlich zeigt die Fig. 8 ein erfindungsgemäßes System zum Belichten, Bohren, Entwickeln und Ätzen eines Substrats. Mit anderen Worten, ein Anwender der eine Leiterplatte am Computer konstruiert, kann die entsprechenden Daten vom Computers direkt an das erfindungsgemäße System übertragen, welches dann aus einem Substrat mit einer Kupferschicht und einem darauf aufgebrachten Fotoresist eine Leiterplatte herstellt. Mit anderen Worten, ein Anwender benötigt nur einen Computer und das erfindungsgemäße System, um fertige Leiterplatten herzustellen.

Im oberen Teil der Fig. 8 sind die einzelnen Arbeitsschritte als Flussdiagramm dargestellt. So wird beispielsweise nach dem Design der gewünschten Leiterbahn am Computer der entsprechende Datensatz an das erfindungsgemäße System übertragen und als erster Arbeitsschritt die Durchkontaktier- bzw. Bohrvorrichtung an die Bewegungseinrichtung gekoppelt, um das Substrat 20 an den gewünschten Stellen zu durchbohren. Anschließend wird die Bohreinrichtung 30 durch die Belichtungseinrichtung 10 ersetzt und der Fotoresist mit Hilfe der Belichtungseinrichtung 10 belichtet, wodurch aufgrund der Bewegung der Belichtungseinrichtung relativ zum Substrat während der Belichtung das konstruierte Muster auf den Fotoresist übertragen wird. Nachfolgend wird der belichtete Fotoresist entwickelt, d.h. die belichteten Stellen oder die unbelichteten Stellen, je nach Fotoresist, werden abgelöst. Anschließend wird gespült und die freigelegten Bereiche der Kupferschicht, d.h. die Bereiche ohne Fotoresist, werden in einem Ätzbad weggeätzt, so dass schließlich nur noch eine Metallschicht unterhalb des Fotoresists erhalten bleibt. In einem letzten Arbeitsschritt wird schließlich die fertige Leiterplatte gespült.

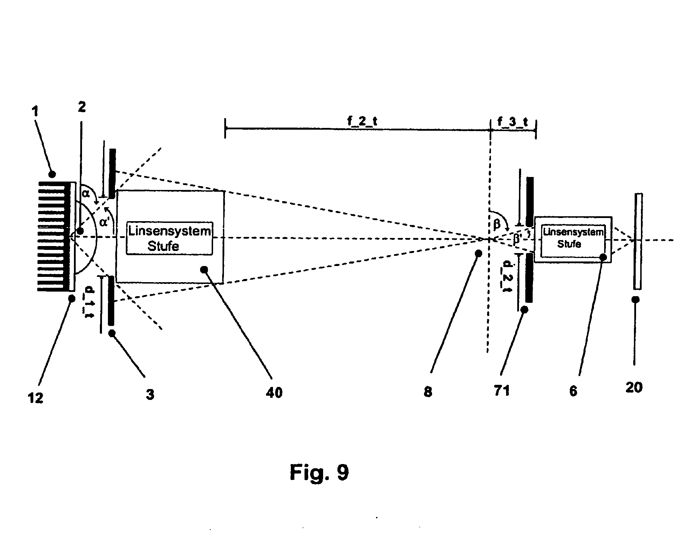

Figur 9 ist eine schematische Darstellung einer Belichtungseinheit 10. Insbesondere wird der der bevorzugte Strahlenverlauf durch die Belichtungseinheit exemplarisch erläutert. Die Belichtungseinheit weist einen Kühlkörper 1 auf, der vorzugsweise aus Aluminium hergestellt ist. Die Lichtquelle, vorzugsweise eine Leuchtdiode 2 ist auf eine wärmeleitende Platine 12, vorzugsweise aus Aluminium, aufgebracht. Zwischen Platine und Kühlkörper befindet sich eine wärmeleitende Verbindung, vorzugsweise Wärmeleitpaste. Die Platine 12 ist vorzugsweise mit dem Kühlkörper mechanisch verbunden oder in den Kühlkörper eingelassen. Die Lichtquelle 2 hat vorzugsweise eine geringe geometrische Größe von 0,1 mm2 bis 1 mm2. Die Lichtquelle 2 kann in ihrem Gehäuse eine Primärlinse aufweisen, vorzugsweise eine Quarzlinse mit Gaußscher Strahlverteilung. Die Lichtquelle an sich hat vorzugsweise einen Abstrahl- bzw. Halbwertswinkel kleiner 90°; wobei der Halbwertswinkel durch die Primärlinse vorzugsweise unterhalb von 50° liegt, d.h. der Abstrahl- bzw. Halbwertswinkel a' des emittierten Lichtes liegt vorzugsweise unter 50° (siehe Fig. 9). Der Abstrahlwinkel bzw. Halbwertswinkel, ist definiert als der Winkel im Bereich von 0° bis 90°, wo die maximale Lichtintensität der Lichtquelle im Vergleich zur Hauptstrahlrichtung meist bei 0° um 50 % abgefallen ist. Anders ausgedrückt; der Abstrahlwinkel T0,5 Einheit [°] oder auch Halbwertswinkel, ist definiert als der Winkel zwischen den beiden Linien, die ausgehend von der LED Spitze die Punkte mit 50% der Maximallichtstärke schneiden (siehe beispielsweise: http://www.leds-com.de /irw_page.416273747261686c77696c6b656c.html).

Der in Figur 9 dargestellte Winkel $\alpha$ ergibt sich aus der Berechnung: 90° - $\alpha$'.

Strahlabwärts von der Lichtquelle 2 ist eine (erste) Aperturblende 3 angeordnet, vorzugsweise bestehend aus einer Rundblende. Die Aperturblende 3 begrenzt in Abhängigkeit der weiter Strahl abwärts angeordneten ersten Linsensystemstufe 40 den Halbwertswinkel der Lichtquelle, wobei der Halbwertwinkel vorzugsweise zwischen 40° und 60° beträgt. Die erste Linsensystem Stufe 40 weist optische Mitteln zur Zwischenfokussierung der Lichtquelle in einer parallel Ebene 8 auf. Eingangsseitig werden vorzugsweise optische Mittel mit geringen Brennweiten und großen Abmessungen bzw. Durchmesser verwendet (f# = Durchmesser /Brennweite ≤ 1). Ausgangsseitig findet durch optische Mittel eine Brennweiten-Ausdehnung vorzugsweise mit großen Brennweiten statt. Hierbei weisen die ausgangsseitigen optischen Mittel vorzugsweise einen größeren Durchmesser wie die Eingangsseitigen optischen Mittel auf damit sichergestellt werden kann, dass die ausgangsseitigen Linsen innerhalb ihres optimalen Arbeitsbereiches (Clear Aperture) arbeiten. Hierbei findet eine vorzugsweise 2 bis 20 fache Verkleinerung der vorzugsweise eng geometrisch aufgebauten Lichtquelle in einer Zwischenebene 8 statt.

Eine neue, imaginäre Lichtquelle mit geringeren Halbwertswinkel β' und veränderter, komprimierter und vorzugsweise kaum geringerer Intensitätsverteilung liegt danach in der Zwischenebene 8 vor. Der in Figur 9 dargestellte Winkel β ist wiederum 90°-β'. Das Verhältnis der Winkel β/α ist vorzugsweise von 4 bis 20. Der Halbwertwinkel der imaginären Zwischenquelle liegt vorzugsweise zwischen 0,1° bis 20°. Eine (zweite) Aperturblende 71 (vorzugsweise bestehend aus einer Rundblende), die strahlabwärts von der imaginären Zwischenquelle 8 angeordnet ist, begrenzt in Abhängigkeit der zweiten Linsensystemstufe 6 den Halbwertswinkel der Lichtquelle, wobei der Halbwertwinkel vorzugsweise zwischen 0,1° bis 20° beträgt. Die zweite Linsensystemstufe 6 weist vorzugsweise optische Mittel mit geringen Brennweiten als die erste Linsensystemstufe 40 auf. Die zweite Linsensystemstufe 6 kann mehrere optische Mittel aufweisen, vorzugsweise mit achromatischen Eigenschaften zur wellenlängenrichtigen Fokussierung. Beispielsweise weist die zweite Linsensystemstufe 6 zumindest eine bikonvexe Sammellinse geringen Durchmessers von unterhalb 5 mm auf oder einen aplanar angeordneten, plankonvexen zweistufigen Linsenaufbau. Die Fokussierung der zweiten Linsensystemstufe 6 liegt vorzugsweise im Bereich 20 bis 100 Fach. Die Gesamtfokussierung der Anordnung ergibt sich vorzugsweise zwischen dem Faktor 20 bis 500. Ausgangsseitig an der zweiten Linsensystemstufe 6 findet wiederum eine Verkleinerung der vorzugsweise eng geometrisch aufgebauten Lichtquelle in einer Zwischenebene 20 statt. Innerhalb dieser Zwischenebene 20 liegt vorzugsweise das Trägersubstrat der zu belichtenden Anordnung. Die in der ersten Linsensystemstufe 40 und in der zweiten Linsensystemstufe 6 eingesetzten optischen Mittel haben vorzugsweise Transmissionsanteile > 90 % im Bereich der Wellenlängen von 350 nm bis 450 nm oder bestehen vorzugsweise aus Materialen wie Quarzglas oder BK7.

Die in Figur 9 schematisch dargestellte bevorzugte Ausführungsform sollte erfindungsgemäß vorzugsweise die folgende mathematische Bedingung erfüllen:

$$d\_2\_t \leq \frac{\cos(90° - \beta)}{\sin(90° - \beta)} \cdot f\_3\_t \cdot 2 \leq \frac{f\_3\_t \cdot 2}{\tan(90° - \beta)} \qquad (1)$$

mit

$$f\_2\_t \geq \frac{d\_1\_t}{d\_2\_t} \cdot f\_3\_t \qquad (2)$$

wobei d_1_t die Öffnung der Aperturblende 3 ist; f_2_t die Distanz vom ausgangsseitigen Ende der ersten Linsenstufensystem 40 zur Zwischenebene 8 ist; d_2_f die Öffnung der Aperturblende 71 ist und f_3_t die Distanz von der Zwischenebene 8 zum eingangsseitigen Ende der zweiten Linsenstufensystem 6 ist.

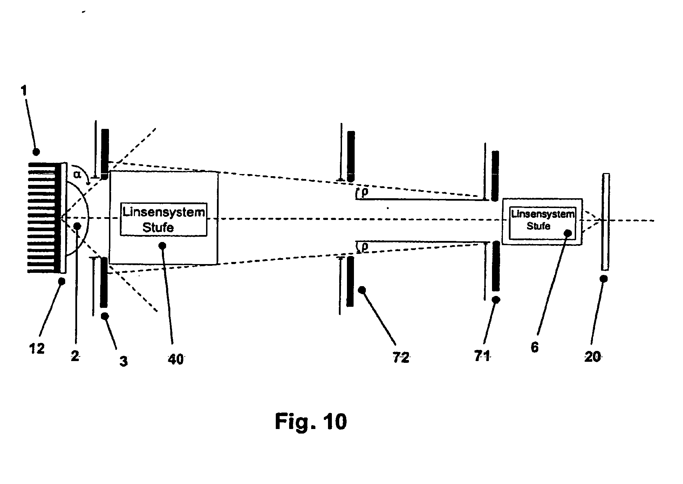

Figur 10 zeigt eine weitere bevorzugte Ausführungsform der Belichtungseinrichtung. Die in Figur 10 dargestellte Ausführungsform ist der in Figur 9 dargestellten Ausführungsform sehr ähnlich, daher wird auf die Beschreibung der gleichen Bauteile verzichtet. Im Gegensatz zur Ausführungsform von Figur 9 erfolgt jedoch eine abgeänderte Zwischenfokussierung unter Verwendung einer (dritten) Aperturblende 72, die zwischen dem ersten Linsensystemstufe 40 und der (zweite) Aperturblende 71 angeordnet ist. Zudem weist die erste Linsensystemstufe 40 optische Mittel vorzugsweise mit Brennweiten größer als der vierfache Durchmesser der optischen Mittel auf.

Hierbei wird die Steigung des Fokuskegels gleich dem Akzeptanzwinkel ρ der eingangsseitigen optischen Mittel der zweiten Linsensystemstufe 6 gesetzt. Die eingangseitigen optischen Mittel der zweiten Linsensystemstufe 6 können plan parallele Strahlen, sowie Strahlen mit geringen Abweichungen (Akzeptanzwinkel, Winkel p) von der horizontalen Ebene korrekt bündeln. Die Aperturblende 72 sowie die Aperturblende 71 filtern Streustrahlung raus, wobei die Aperturblende 72 und oder die Aperturblende 71 vorzugsweise als Rundblenden ausgebildet sind.

Die zweite Linsensystemstufe 6 kann mehrere optische Mittel aufweisen, vorzugsweise jedoch mindestens eine plankonvexen Sammellinse geringen Durchmessers von unterhalb 5 mm. Die Fokussierung der zweiten Linsensystemstufe 6 liegt vorzugsweise im Bereich 20 bis 100 Fach. Die Gesamtfokussierung der Anordnung ergibt sich vorzugsweise zwischen dem Faktor 20 bis 500. Ausgangsseitig an der zweiten Linsensystemstufe 6 findet wiederum eine Verkleinerung in die Zwischenebene 20 statt.

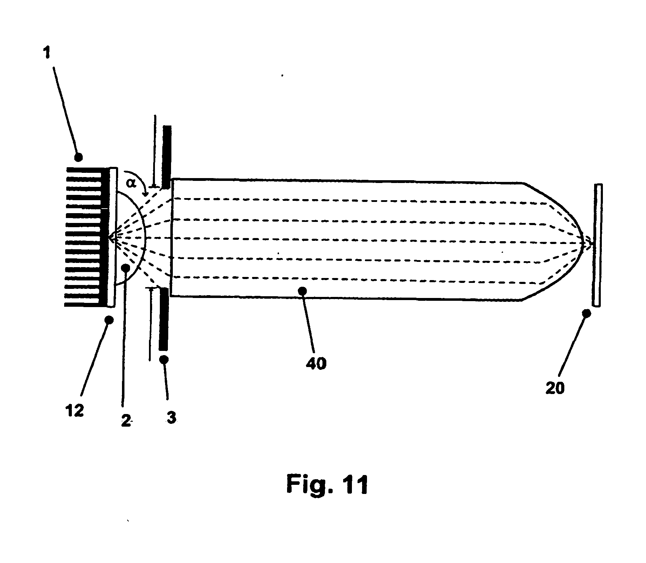

Figur 11 zeigt eine weitere bevorzugte Ausführungsform der Belichtungseinrichtung. Auch die in Figur 11 dargestellte Ausführungsform ist der in Figur 9 dargestellten Ausführungsform in gewisser Hinsicht ähnlich; daher wird auf die Beschreibung der gleichen Bauteile verzichtet. Im Gegensatz zu den in Figuren 9 und 10 dargestellten Ausführungsformen ist die erste Linsensystemstufe 40 konkret als GRIN-Linse (GradientenIndex-Linse) 40 dargestellt. Die GRIN-Linse fängt die punkförmige Strahlung der Lichtquelle 2 auf und fokussiert darauf folgend die Strahlung in einem Punkt. Innerhalb dieses Fokuspunktes liegt vorzugsweise das Trägersubstrat 20 der zu belichtenden Anordnung. Die GRIN-Linse korrigiert hierbei die Effekte der chromatischen Dispersion.

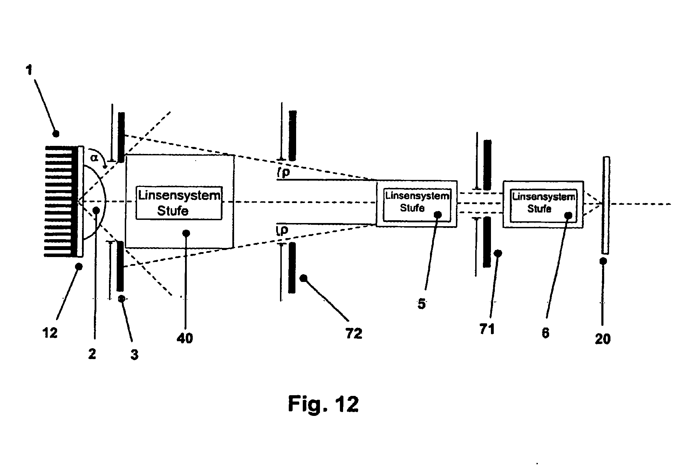

Figur 12 zeigt eine weitere bevorzugte Ausführungsform der Belichtungseinrichtung. Auch die in Figur 12 dargestellte Ausführungsform ist der in Figur 9, insbesondere der in Figur 10 dargestellten Ausführungsform ähnlich; daher wird auf die Beschreibung der gleichen Bauteile verzichtet. Im Gegensatz zu den in Figuren 9 und 10 dargestellten Ausführungsformen weist diese Ausführungsform drei Linsensystemstufen auf.

In dieser Ausführungsform wird die Steigung des Fokuskegels gleich dem Zerstreuungswinkel der eingangsseitigen optischen Mittel einer dritten Linsensystemstufe 5 gesetzt, wobei die erste Linsensystemstufe 40 zwischen der Aperturblende 3 und 72 angeordnet ist; die dritte Linsensystemstufe 5 zwischen der Aperturblende 72 und 71 angeordnet ist; und die zweite Linsensystemstufe 6 zwischen der Aperturblende 71 und der Zwischenebene 20 angeordnet ist.

Die eingangseitigen optischen Mittel der dritten Linsensystemstufe 5 (vorzugsweise eine plan-konkave Zerstreuungslinse mit geringem geometrischen Maßen < 8 mm) parallelisieren die einfallenden Strahlen bis zu einem Öffnungswinkel (Winkel p). Die Aperturblende 72 sowie die Aperturblende 71 filtern Streustrahlung aus.

Die zweite Linsensystemstufe 6 kann aus mehreren optischen Mitteln bestehen, vorzugsweise jedoch aus einer plankonvexen Sammellinse geringen Durchmessers von unterhalb 5 mm. Die Fokussierung der zweiten Linsensystemsstufe 6 liegt vorzugsweise im Bereich 20 bis 100 Fach. Die Gesamtfokussierung der Anordnung ergibt sich vorzugsweise zwischen dem Faktor 20 bis 500. Die in der ersten, zweiten und dritten Linsensystemstufe 40, 5 und 6 eingesetzten optischen Mittel haben vorzugsweise Transmissionsanteile > 90 % im Bereich der Wellenlängen von 350 nm bis 450 nm oder bestehen vorzugsweise aus Materialen wie Quarzglas oder BK7.

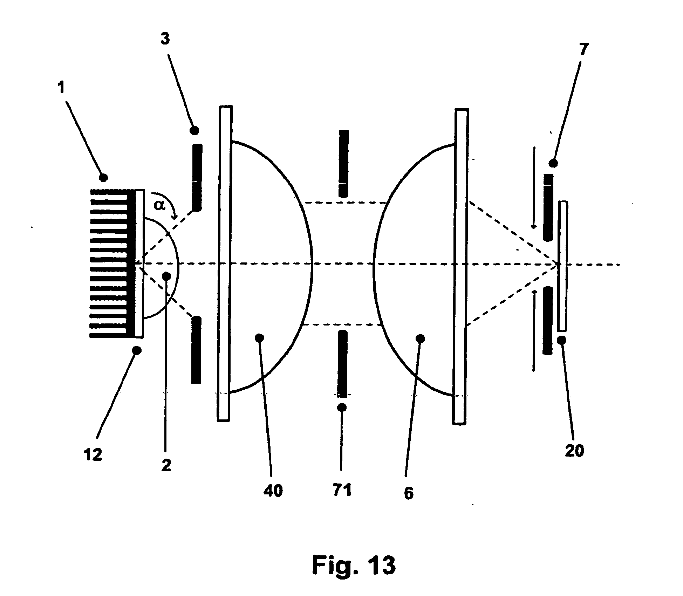

Figur 13 zeigt eine weitere bevorzugte Ausführungsform der Belichtungseinrichtung. Auch in der in Figur 13 dargestellten Ausführungsform finden sich Elemente (Bauteile) die bereits in den Figuren 9 bis 12 detailliert beschreiben wurden. Es wird daher auf eine wiederholte Beschreibung bereits beschriebener, gleichwertiger Elemente verzichtet.

Die Aperturblende 3 begrenzt wiederum in Abhängigkeit einer ersten Linsensystemstufe, die der Aperturblende 3 nachgeschaltet ist, den Halbwertswinkel des abgestrahlten Lichtes, wobei der Halbwertwinkel vorzugsweise zwischen 20° und 40° begrenzt wird. In der dargestellten Ausführungsform wird die erste Linsensystemstufe durch eine Linse 40 repräsentiert. Die plankonvexe, vorzugsweise asphärische, Kondensorlinse 40 (vorzugsweise mit geringer Brennweite unterhalb von 10 mm und vorzugsweise mit der planen Seite zur Lichtquelle angeordnet) formt einen parallelen Strahlengang. Der Linsendurchmesser wird vorzugsweise so gewählt, dass die Linse hauptsächlich im Mittelbereich < 50 % des Durchmessers bestrahlt wird. Die nachgeschaltete Aperturblende 71 (vorzugsweise eine Rundblende) entfernt in Abhängigkeit der Linse 40 auftretende Streustrahlung. Die, vorzugsweise aplanar angeordnete zweite (vorzugsweise asphärische) Linse 6, die vorzugsweise eine geringe Brennweite aufweist, fokussiert die Strahlen in einem Fokuspunkt in einer Zwischenebene 20. Innerhalb dieser Zwischenebene 20 liegt vorzugsweise das Trägersubstrat der zu belichtenden Anordnung. Zur Streustrahlunterdrückung oder zur Auflösungserhöhung kann eine weitere Aperturblende 7 (vorzugsweise bestehend aus einer Rundblende) in den Fokussierungskegel der zweiten Linse 6 angebracht werden. Diese Blende kann verstellbar ausgestaltet sein, vorzugsweise durch eine Kombination aus einer elektro-mechanischen Ansteuerung.

Figur 14 zeigt eine weitere bevorzugte Ausführungsform der Belichtungseinrichtung in einer Querschnittsansicht. Im Gegensatz zu den Figuren 10 bis 13 zeigt diese Ausführungsform mehrere Lichtquellen die vorzugsweise in einem 2D-Array bzw. einer 2D-Matrix, ähnlich wie in Figur 6, angeordnet sind.

Die Belichtungseinheit weist wiederum einen Kühlkörper 1 auf, der vorzugsweise aus Aluminium hergestellt ist. Die Lichtquelle umfasst hier mehrere einzelne Lichtquellen, vorzugsweise eine Anordnung von Leuchtdiodenemittern (LEDs) die auf einer Platine angeordnet sein können. So kann die Anordnung beispielsweise ein Halbleiterchip 101 (Array) sein. Vorzugsweise sind die einzelnen Lichtemitter auf einer Wärme leitenden Platine angeordnet. Um Wärme von der Platine abzuleiten, ist die Platine mit dem Kühlkörper über eine Wärme leitende Verbindung verbunden, vorzugsweise unter Verwendung einer geeigneten Wärmeleitpaste. Die Platine ist vorzugsweise auf dem Kühlkörper mechanisch befestigt oder in den Kühlkörper eingelassen. Vorzugsweise hat jede der mehreren Lichtquellen 2 eine geringe geometrische Größe von 0,1 mm$^2$ bis 1 mm$^2$. Zudem ist es bevorzugt, dass jede Lichtquelle 2 eine Primärlinse, vorzugsweise eine Quarzlinse mit Gaußscher Strahlverteilung, aufweist. In der bevorzugten dargestellten Ausführungsform hat jede Lichtquelle einen Halbwertswinkel < 70°. Anders ausgedrückt, es ist bevorzugt, dass der Halbwertswinkel nach der Primärlinse unterhalb von 20° liegt. Durch eine elektrische, vorzugsweise externe Ansteuerung, kann vorzugsweise jede einzelne Lichtquelle oder Gruppen der Lichtquellen mittels einer Puls-Weiten-Modulation (PWM) im variablen Pulsmodus betrieben werden.

Mittels einer relativ zur einzelnen Lichtquelle 2 angeordneten optischen Linse 40, vorzugsweise eine bikonvexe Sammellinse mit geringer Brennweite, werden die Strahlen jeder einzelnen Lichtquelle im Wesentlichen parallelisiert. Diese Anordnung an optischen Mittel in geringem Abstand relativ angeordnet zur Anzahl der Leuchtmittel kann vorzugsweise bei einer Anordnung von einzelnen Emitterdioden als Linsenarray 2 und bei Halbleiter-Array-Lichtquellen als Mikrolinsenarray 40 ausgeführt werden. Durch eine, vorzugsweise zwischen 0,1 und 2 mm entfernt am Linsenarray angebrachte Fokussierungslinse 5, vorzugsweise mit Brennweiten zwischen 10 mm und 25 mm wird eine optische Zwischenebene 8 geschaffen.

Durch diese optisch generierte Zwischenebene findet eine Annäherung an eine punktförmige Lichtquelle mit endlicher Ausdehnung und einem geringen Halbwertswinkel in 8 statt. Hierbei liegt die Verkleinerung der Ausgangsquelle vorzugsweise zwischen 20 und 50. Ausgehend von dieser geometrisch kleineren, nun annähernd punktförmigen Lichtquelle fokussiert ein nachgeschaltetes Linsensystem 6, vorzugsweise mit achromatischen Eigenschaften zur wellenlängenrichtigen Fokussierung, die Anordnung in eine Fokusebene 20. Vorzugsweise umfasst das Linsensystem 6 eine bikonvexen Linse mit geringer Brennweite von unterhalb 5 mm oder eine aplanaren Anordnung von zwei plankonvexen Linsen mit geringer Brennweite von unterhalb 5 mm. Innerhalb dieser Ebene 20 liegt vorzugsweise das Trägersubstrat der zu belichtenden Anordnung. Zur Streustrahlunterdrückung kann eine Aperturblende 71, vorzugsweise bestehend aus einer Rundblende, in den Fokussierungskegel eingebaut werden.

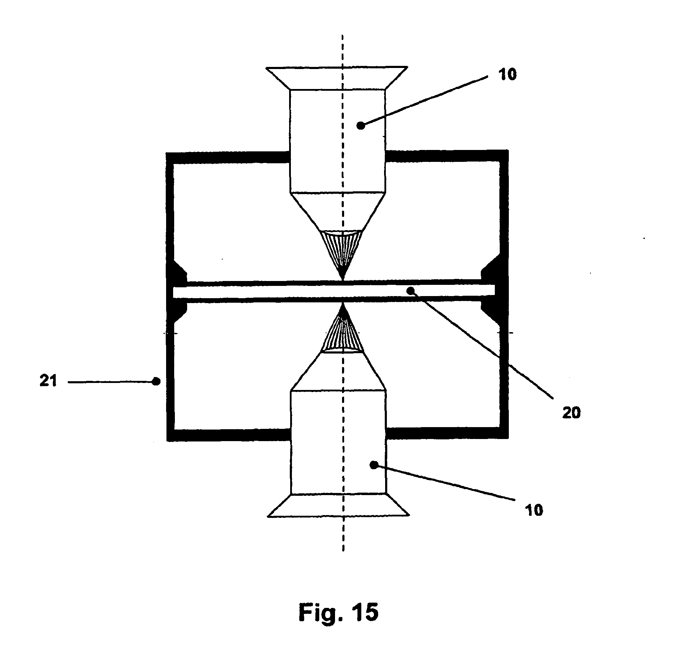

Figur 15 zeigt eine seitliche Schnittansicht einer Lithographiebelichtungseinrichtung mit zwei Belichtungseinrichtungen 10 die zur gleichzeitigen Belichtung eines doppelseitig beschichteten Substrats ober- und unterhalb des Substrats angeordnet sind.

So kann erfindungsgemäß zur Belichtung eines doppelseitig beschichteten Substrates 20 eine zeitgleiche Strukturierung durch zwei oder wahlweise mehrere Belichtungseinheiten 10 durchgeführt werden. Dabei werden vorzugsweise beide Belichtungseinheiten gleichzeitig angesteuert. Eine mechanische Vorrichtung 21 dient vorzugsweise zur Justierung des Trägermaterials, wodurch die Relativbewegung zwischen Substrat und Belichtungseinrichtung realisiert wird. Die Vorschubgeschwindigkeit der Belichtungseinheiten ist vorzugsweise individuell einstellbar.

Abbildung 16 zeigt einen erfindungsgemäßen Regelkreis zur (Fein)justierung bzw. Kalibrierung der Belichtungseinheit 10 über dem Trägermaterial 20.

Eine Photodiode 22, vorzugsweise eine SI-PIN Diode mit einem Wirkungsgrad (SF > 0,2 A/W bei 380nm) ist vorzugsweise auf gleicher Höhe wie die Arbeitsfläche 21 der Anlage installiert. Die Wirkungsfläche der Photodiode 22 ist vorzugsweise von geringen geometrischen Ausmaßen, vorzugsweise von 0,05 mm$^2$ bis 1 mm$^2$. Vorzugsweise ist eine Blende 73, beispielsweise eine Rundblende, oberhalb der Wirkfläche der Photodiode angebracht, um die Wirkfläche der Photodiode zu begrenzen. Vorzugsweise kann oberhalb der Wirkfläche der Photodiode ein optisches Filter für bestimmte Wellenlängen oder ein optisches Dämpfungsglied angebracht werden.

Durch den Einfall der Strahlen der Belichtungseinheit 10 wird die Lichtleistung proportional durch die Photodiode in einen elektrischen Strom gewandelt. Der Spannungsabfall dieses Stromes über vorzugsweise einen elektrischen Shunt-Widerstand kann mittels einer Analog / Digital Konversion 23 die Leistung vorzugsweise als Datenwert in einen Mikrocontroller eingelesen werden. Vorzugsweise mittels Software Umnormierung bzw. Umrechnung 24 kann die eingefallene Lichtleistung abgeleitet werden. Durch die Kenntnis der maximalen Lichtintensität der Belichtungseinheit im idealen Brennpunkt wird vorzugsweise mittels einer geringen Hysterese eine minimale und maximale Schranke in einer Softwareanwendung oder Datenbank gespeichert. Vorzugsweise innerhalb einer digitalen Komponente wie z.B. einem Mikrocontroller wird die aktuelle Lichtintensität (Ist-Größe) mit der bekannten maximalen Intensität im Brennpunkt der Belichtungseinheit (Soll-Größe) verglichen. Unterschreitet die Ist-Größe die minimale Schranke der Soll-Größe wird ein Signal zur Positionierungsänderung der Belichtungseinheit 25 von 0,1 mm Schritten oder kleineren Schritten, vorzugsweise durch eine mechanische Z-Achsen Positionierungseinheit erteilt, solange die Ist-Größe ungleich der Soll-Größe ist. Ist dies nicht mehr der Fall bzw. liegt der gemessene Lichtleistungswert innerhalb der Hysterese-Schranken so liegt der Brennpunkt der Belichtungseinheit näherungsweise auf der Arbeitsfläche.

Die Kalibrierung auf die individuelle Höhe des zu belichtenden Trägermaterials findet anschließend vorzugsweise über die manuelle Benutzereingabe der Höhe des verwendeten Trägermaterials oder über die Auswahl von bereits gespeicherten Informationen in einer Datenbank statt. Die sich ergebende Offset-Höhe 20 wird vorzugsweise über eine Z-Achsen Mechanik in der Position der Belichtungseinheit korrigiert. Der individuelle Kalibrierungsvorgang ist somit abgeschlossen.

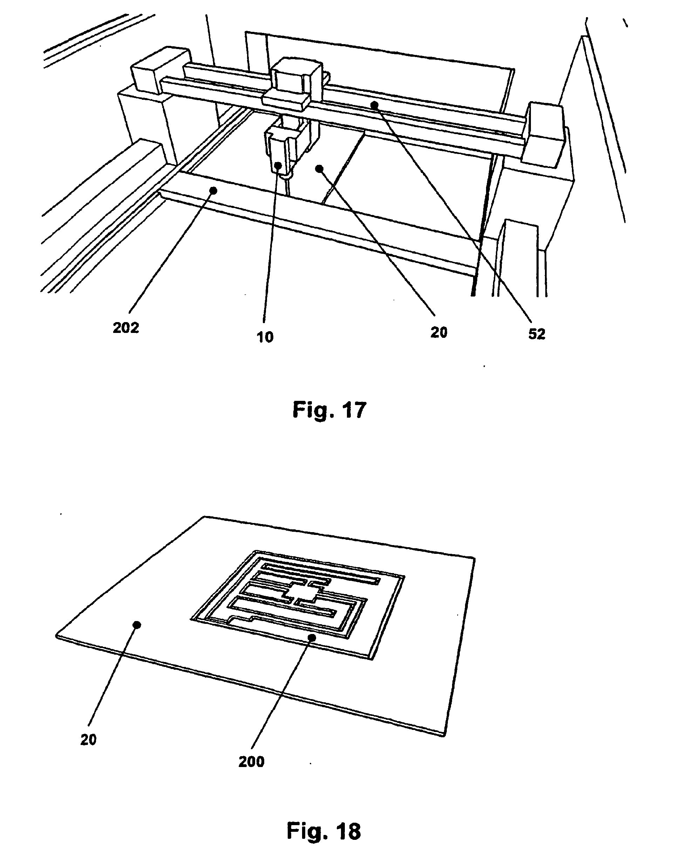

Figur 17 zeigt ähnlich wie Figur 1 eine erfindungsgemäße Lithografiebelichtungseinrichtung. Die Belichtungseinrichtung 10 kann entlang der Schienen 52 bewegt werden, wodurch die Relativbewegung zwischen der Belichtungseinrichtung 10 und dem Substrat 20 erreicht wird. Durch diese Anlage wird vorzugsweise mittels einer punktförmigen Isolationsbelichtung der Schaltungsträger durch die Belichtungseinheit 10 belichtet. Hierbei werden auf einem Leiterplattennutzen bzw. Substrat 20 (vorzugsweise in genormter Leiterplattengröße) mehrere Teilschaltungen bzw. Teilplatinen belichtet. Hierbei wird nach dieser Strukturierung um jede Teilschaltung eine Belichtung einer Rahmenform, vorzugsweise ein Viereck durchgeführt. Der Leiterplattennutzen wird vorzugsweise durch eine Fixierungseinheit 202 festgespannt.

Nach dem Entwicklung- und Ätzprozess ist neben der Strukturierung der Leiterplatte 20 auch auf der Rahmenbelichtung das beschichtete Material 200 (vorzugsweise Kupfer) abgetragen worden. Somit ist eine "reine Substratfläche" um die eigentliche Schaltung als Rahmen freigelegt (siehe Figur 18).

Diese Rahmen können zur Unterteilung der einzelnen Schaltungen dienen bzw. können individuelle Schaltungsträgerformen vorgeben. Zudem kann entlang des Rahmens, das Substrat zerteilt werden. Insbesondere kann in einem weiteren Fertigungsschritt mittels der Belichtungseinheit 10 selbst, oder durch eine extra Laserdiode oder ein Laserdioden-Array oder durch die Belichtungseinheit 10, bei der die UV Leuchtdioden durch Wärmestrahlung emittierenden infraroten LED ausgetauscht werden, das Trägermaterial entlang des Rahmens, bei dem vorzugsweise das Kupfer bereits im Ätzschritt abgetragen wurde, schrittweise und vorzugsweise direkt abgetragen werden. Hierbei wird die Ablationsschwelle des Trägermaterials überschritten und es findet eine schrittweise vorzugsweise sofortige Vaporisierung des Trägermaterials statt. Hierdurch wird die Einzelschaltung vom Gesamtnutzen getrennt. Der Leiterplattennutzen wird vorzugsweise durch eine Fixierungseinheit 202 festgespannt (siehe Figur 19).

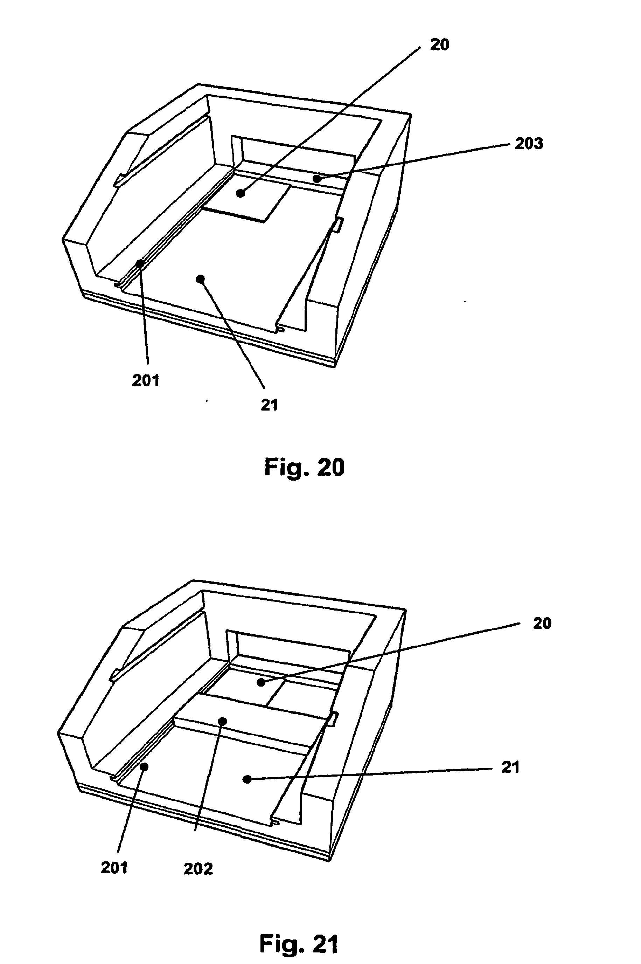

Figur 20 zweigt eine perspektivische Ansicht einer erfindungsgemäßen Lithographiebelichtungseinrichtung mit einer Arbeitsfläche die viereckig aufgebaut ist. An den beiden Seiten der Arbeitsfläche 21 sind Seitenwände vorgesehen, die vorzugsweise mindestens 5 cm hohe sind und vorzugsweise jeweils eine durchgehende Schienenführung 201 aufweisen. Zudem kann eine hintere Seitenwand 203 vorgesehen sein, die vorzugsweise manuell herausnehmbar ist. Das vorzugsweise viereckige Trägermaterial 20 wird vorzugsweise zwischen mindestens einer der Seitenwände und einer Schienenwand, vorzugsweise der hinteren Seitenwand fixiert.

Figur 21 zeigt eine ähnliche Ausführungsform wie Figur 20, jedoch mit einem zusätzlichen Schienenführungsblock 202, wobei der eine oder mehrere Schienenführungsblöcke 202 vorzugsweise entlang der beide Schienenführungen 201 zum Trägermaterial 20 geführt werden. Durch eine vorzugsweise magnetische oder mechanische Einrastung der Konstruktion an den Rändern der Arbeitsfläche kann das Trägermaterial angepresst werden.

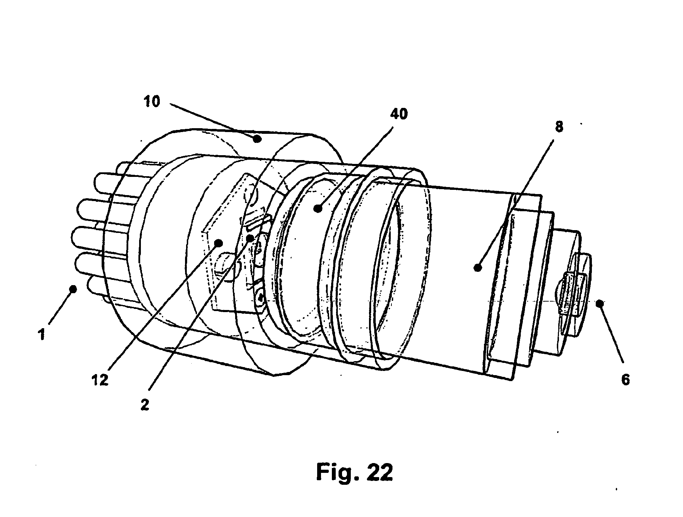

Schließlich zeigt Figur 22 eine weitere Ausführungsform einer Belichtungseinrichtung in einer teilweise durchsichtigen perspektivischen Ansicht. In dieser Darstellung wird die Belichtungseinrichtung 10 mit der Wärme leitenden Platine 12, der Lichtquelle 2 (vorzugsweise UV-Leuchtdiode), einer ersten primären Linsensystemstufe 40, einer parallelen Abbildungsebene 8 und einer zweiten Linsensystemstufe 6 zur Fokussierung der Strahlung in einer weiteren Zwischenebene, in welcher vorzugsweise das zu belichtende Substrat (20) liegt, dargestellt.

**Patentansprüche**

1. Lithografiebelichtungseinrichtung (42) für eine maskenlose Direktbelichtung eines Musters auf einem Substrat mit:

   einer Belichtungseinrichtung (10) zum direkten Belichten eines Musters auf ein Substrat (20), das eine lichtempfindliche Schicht aufweist; und
   einer Bewegungseinrichtung zur Erzeugung einer Relativbewegung zwischen der Belichtungseinrichtung (10) und dem Substrat (20);
   wobei die Belichtungseinrichtung (10) eine Lichtquelle mit mindestens einer Leuchtdiode (2) aufweist, die zumindest UV-Licht mit einem Abstrahlwinkel $\alpha'$ emittiert, und wobei die Belichtungseinrichtung optische Mittel (40, 6) aufweist, die den Abstrahlwinkel $\alpha'$ des von der Lichtquelle emittierten Lichtes stufenweise reduzieren; und wobei die Belichtungseinrichtung eine variabel verstellbare Blende (7) aufweist, und das abgestrahlte Licht schließlich auf dem Substrat in einem Belichtungsfleck zumindest bündelt.

2. Lithografiebelichtungseinrichtung nach Anspruch 1, wobei die optischen Mittel (40, 6) eine erste Linsensystemstufe (40) aufweisen, die den Abstrahlwinkel $\alpha'$ des von der Lichtquelle abgestrahlten Lichtes reduziert und eine zweite Linsensystemstufe (6) die das mit reduziertem Abstrahlwinkel $\beta'$ abgestrahlte Licht auf dem Substrat (20) auf einen Belichtungsfleck mit einer festgelegten Ausdehnung, vorzugsweise in einem Brennpunkt fokussiert.

3. Lithografiebelichtungseinrichtung nach Anspruch 1 oder 2, wobei die variable Blende während der Direktbelichtung in Abhängigkeit eines Signals von einer Steuereinrichtung veränderbar ist.

4. Lithografiebelichtungseinrichtung nach Anspruch 1, 2 oder 3, wobei die Intensität der Leuchtdiode (2) in Abhängigkeit eines Signals von einer Steuereinrichtung veränderbar ist.

5. Lithografiebelichtungseinrichtung nach einem der Ansprüche 1 bis 4, wobei die optischen Mittel zumindest ein aplanatisches, asphärisches Kondensorlinsensystem (4, 6) aufweisten:

6. Lithografiebelichtungseinrichtung nach einem der vorhergehenden Ansprüche, wobei die optischen Mittel zumindest teilweise Linsen aufweisen, die aus Borsilikatglas, BK7, bzw. SF10 hergestellt sind, wobei die Linsen vorzugsweise einen Transmissionsanteil von > 90% im Wellenlängenbereich von 350nm bis 1000nm aufweisen.

7. Lithografiebelichtungseinrichtung nach einem der vorhergehenden Ansprüche, wobei die Bewegungseinrichtung angepasst ist, um:

   (a) eine Relativbewegung in zwei Dimensionen, vorzugsweise parallel zum Substrat (20), zu ermöglichen, und/oder
   (b) eine Relativbewegung in drei Dimensionen, vorzugsweise parallel und senkrecht zum Substrat (20), zu ermöglichen.

8. Lithografiebelichtungseinrichtung nach einem der vorhergehenden Ansprüche, wobei die Lichtquelle mehrere UV-Licht emittierende Leuchtdioden (2) aufweist, die vorzugsweise individuell angesteuert werden können, wobei das emittierte Licht der mehreren Leuchtdioden (2) durch ein (i) Mikrolinsenarray und/oder (ii) eine Flächenanordnung von konvexen Linsen parallelisiert wird, bevor es auf den Belichtungsfleck gebündelt wird.

9. Lithografiebelichtungseinrichtung nach einem der vorhergehenden Ansprüche, wobei für eine doppelseitige Belichtung des Substrats (20) mindestens eine Belichtungseinrichtung (10) oberhalb des Substrats (20) angeordnet ist und mindestens eine Belichtungseinrichtung (10) unterhalb des Substrats (20) angeordnet ist, wobei die beiden Belichtungseinrichtungen (10) vorzugsweise unabhängig voneinander bewegt werden können.

10. Lithografiebelichtungseinrichtung nach einem der vorhergehenden Ansprüche, mit einer Justageeinrichtung (22, 23, 24, 25) zur Justage des Belichtungsflecks bzw. Fokussierpunktes auf dem Substrat (20), wobei die Justageeinrichtung eine Photodiode (22) aufweist, mit der die Intensität des von der Belichtungseinrichtung (10) emittierten Lichtes gemessen wird, und der Abstand zwischen der Belichtungseinrichtung (10) und dem Substrat (20) in Abhängigkeit der gemessenen Intensität verändert wird.

11. Lithografiebelichtungseinrichtung nach einem der vorhergehenden Ansprüche, mit einer Substrat-Befestigungseinrichtung die aufweist:

   mindestens zwei im Wesentlichen rechtwinklig zueinander angeordnete Ausrichtungskanten (203), an denen zwei Seiten eines rechtwinkligen Substrats ausgerichtet werden können; und
   einen versetzbaren Anschlag (202), der über eine Schienenführung (201) und/oder über magnetische Elemente und/oder Stifte das Substrat (20) an zumindest einer dritten Seite fixiert.

12. System zum Herstellen einer Leiterplatte mit:

   - einer Lithografiebelichtungseinrichtung (42) nach einem der vorhergehenden Ansprüche zum Belichten eines Substrats (20) mit lichtempfindlicher Schicht, und
   - einer Entwicklungs-Ätzvorrichtung zum Entwickeln und Ätzen des mit der Lithografiebelichtungseinrichtung belichteten Substrats (20).

13. Verfahren zum direkten strukturierten lithografischen Belichten eines Substrats (20) mit einer lichtempfindlichen Schicht mit den Schritten:

   - Bereitstellen einer Lithografiebelichtungseinrichtung (42) mit mindestens einer eine UV-Leuchtdiode (2) aufweisenden Belichturigseinrichtung (10) nach einem der Ansprüche 1 bis 11,
   - Anordnen des Substrats (20), sodass die lichtempfindliche Schicht mit dem von der Belichtungseinrichtung (10) emittierten Licht belichtet werden kann,
   - Belichten des Substrats (20) mit der Belichtungseinrichtung (10).

14. Verfahren nach Anspruch 13, wobei durch einen zeilenförmigen Vorschub entlang einer ersten Achse die Belichtungseinrichtung (10) relativ zum Substrat bewegt wird und die Belichtungseinrichtung (10) in einer Zeile entlang einer zweiten Achse, die im wesentlichen senkrecht zur ersten Achse ist, relativ bewegt wird, wobei während der Bewegung entlang der zweiten Achse die Intensität des emittierten Lichtes zur Strukturbelichtung variiert werden kann.

15. Verfahren nach Anspruch 13 oder 14, wobei der Abstand zwischen Belichtungseinrichtung (10) und Substrat (20) während der Belichtung veränderbar ist, wodurch die Ausdehnung des fokussierten Belichtungsflecks auf dem Substrat veränderbar ist und während einer Relativbewegung entsprechend unterschiedlich breite Linien auf dem Substrat belichtet werden können.

**16.** Verfahren nach einem der Ansprüche 13 bis 15, wobei ein doppelseitig beschichtetes Substrat (20) auf einer Oberseite durch eine erste Belichtungseinrichtung (10) belichtet wird und auf einer Unterseite durch eine zweite Belichtungseinrichtung (10) belichtet wird, wobei die erste und zweite Belichtungseinrichtungen (10) unabhängig voneinander bewegt werden.

**17.** Verfahren nach einem der Ansprüche 13 bis 16, mit den zusätzlichen Schritten:

- Belichten von mindestens einem Rahmen um eine belichtete Struktur auf dem Substrat,
- Entwickeln und Ätzen des gesamten belichteten Substrats, wobei an den belichteten Rahmen lediglich ein Restsubstrat übrig bleibt; und
- Zerteilen des Substrats entlang des mindestens einen Rahmens durch schichtweise Entfernen des Restsubstrats in den Rahmen mit Hilfe von Licht aus der Belichtungseinrichtung (10) und/oder einer zusätzlichen Belichtungseinrichtung.

**Claims**

**1.** A lithographic exposure means (42) for a maskless direct exposure of a pattern on a substrate, comprising:

an exposure means (10) for directly exposing a pattern on a substrate (20) provided with a photosensitive layer; and
a motion means for creating a relative motion between the exposure means (10) and the substrate (20);
wherein the exposure means (10) comprises a light source with at least one light-emitting diode (2) which emits at least UV light at an angle of radiation $\alpha'$, and wherein the exposure means comprises optical means (40, 6) stepwise reducing the angle of radiation $\alpha'$ of the light emitted by the light source, and wherein the exposure means comprises a variably adjustable aperture (7),
and eventually at least focuses the radiated light on the substrate in an exposure spot.

**2.** The lithographic exposure means according to claim 1, wherein the optical means (40, 6) comprise a first lens system stage (40) which reduces the angle of radiation $\alpha'$ of the light radiated from the light source and a second lens system stage (6) which focuses the light radiated at the reduced angle of radiation $\beta'$ on the substrate (20) on an exposure spot having a predetermined expansion, preferably in a focus.

**3.** The lithographic exposure means according to claim 1 or 2, wherein the variable aperture can be changed as a function of a signal from a control means during the direct exposure.

**4.** The lithographic exposure means according to claim 1, 2 or 3, wherein the intensity of the light-emitting diode (2) can be changed as a function of a signal from a control means.

**5.** The lithographic exposure means according to any one of claims 1 to 4, wherein the optical means comprise at least one aplanatic, aspheric condenser lens system (4, 6).

**6.** The lithographic exposure means according to any one of the preceding claims, wherein the optical means at least partially comprise lenses made of borosilicate glass, BK7 and/or SF10, wherein the lenses preferably have a transmission share of > 90% in the spectral range of 350 nm to 1000 nm.

**7.** The lithographic exposure means according to any one of the preceding claims, wherein the motion means is adapted to

(a) enable a relative motion in two dimensions, preferably parallel to the substrate (20), and/or
(b) enable a relative motion in three dimensions, preferably parallel and perpendicular to the substrate (20).

**8.** The lithographic exposure means according to any one of the preceding claims, wherein the light source comprises a plurality of UV light-emitting diodes (2) which preferably can be individually controlled, wherein the emitted light of the plurality of light-emitting diodes (2) is parallelized by (i) a microlens array and/or (ii) an area array of convex lenses before it is focussed on the exposure spot.

**9.** The lithographic exposure means according to any one of the preceding claims, wherein at least one exposure means (10) is arranged above the substrate (20) and at least one exposure means is arranged below the substrate (20) in order to expose the substrate (10) on both sides, wherein the two exposure means (10) preferably can be moved independently from each other.

10. The lithographic exposure means according to any one of the preceding claims, comprising an adjustment means (22, 23, 24, 25) for adjusting the exposure spot or focussing point on the substrate (20), wherein the adjustment means comprises a photodiode (22) by means of which the intensity of the light emitted by the exposure means (10) is measured, and the distance between the exposure means (10) and the substrate (20) is varied as a function of the measured intensity.

11. The lithographic exposure means according to any one of the preceding claims, comprising a substrate attachment means comprising:

   at least two alignment edges (203) which are arranged substantially perpendicularly with respect to each other and at which two sides of a rectangular substrate can be aligned, and
   a displaceable limit stop (202) which fixes the substrate (20) at least at a third side via a rail guide (201) and/or via magnetic elements and/or pins.

12. A system for producing a printed circuit board, comprising:

   - a lithographic exposure means (42) according to any one of the preceding claims for exposing a substrate (20) comprising a photosensitive layer, and
   - a developing-etching device for developing and etching the substrate (20) exposed to the lithographic exposure means.

13. A method for directly and lithographically exposing in a structured way a substrate (20) comprising a photosensitive layer, comprising the steps of:

   - providing a lithographic exposure means (42) comprising at least one exposure means (10) comprising a UV light-emitting diode (2) according to any one of claims 1 to 11,
   - arranging the substrate (20) such that the photosensitive layer can be exposed to the light emitted by the exposure means (10),
   - exposing the substrate (20) to the exposure means (10).

14. The method according to claim 13, wherein the exposure means (10) is moved relative to the substrate by means of a linear feed motion along a first axis and the exposure means (10) is relatively moved in a line along a second axis which is substantially perpendicular to the first axis,
   wherein the intensity of the emitted light can be varied during the motion along the second axis in order to expose structures.

15. The method according to claim 13 or 14, wherein the distance between the exposure means (10) and the substrate (20) can be changed during the exposure, whereby the expansion of the focussed exposure spot on the substrate can be changed and lines on the substrate having accordingly different widths can be exposed during a relative motion.

16. The method according to claims 13 to 15, wherein a substrate (20) coated on both sides is exposed on an upper side by a first exposure means (10) and on a lower side by a second exposure means (10), wherein the first and second exposure means (10) are moved independently from each other.

17. The method according to any one of claims 13 to 16, comprising the additional steps of:

   - exposing at least one frame around an exposed structure on the substrate,
   - developing and etching the entire exposed substrate, wherein only a residual substrate is left at the exposed frames, and
   - dividing the substrate along the at least one frame by removing the residual substrate in the frames layer by layer with the aid of light from the exposure means (10) and/or an additional exposure means.

**Revendications**

1. Dispositif d'éclairage par lithographie (42) pour un éclairage en directe sans masque d'un motif sur un substrat comprenant

   un dispositif d'éclairage (10) pour un éclairage direct d'un motif sur un substrat (20) comprenant une couche photosensible ; et

   un dispositif de mouvement pour générer un mouvement relatif entre le dispositif d'éclairage (10) et le substrat (20) ;

   dans lequel le dispositif d'éclairage (10) comprend une source de lumière avec au moins une diode luminescente (2) émettant au moins de la lumière UV avec un angle de départ α', et dans lequel le dispositif d'éclairage comprend des moyens optiques (40, 6) réduisant l'angle de départ α' de la lumière émis par la source de lumière en étapes, et dans lequel le dispositif d'éclairage comprend une ouverture (7) variablement ajustable,

   et la lumière émis concentre finalement au moins en forme d'une tache lumineuse sur le substrat.

2. Dispositif d'éclairage par lithographie selon la revendication 1, dans lequel les moyens optiques (40, 6) comprennent une première étape de système de lentille (40) réduisant l'angle de départ α' de la lumière émis par la source de lumière et une seconde étape de système de lentille (6) focalisant la lumière émis avec un angle de départ réduit β' sur le substrat (20) sur une tache lumineuse d'une taille prédéterminée, de préférence sur un foyer.

3. Dispositif d'éclairage par lithographie selon la revendication 1 ou 2, dans lequel l'ouverture variable est variable durant l'éclairage direct en fonction d'un signal d'un dispositif de réglage.

4. Dispositif d'éclairage par lithographie selon la revendication 1, 2 ou 3, dans lequel l'intensité de la diode luminescente (2) est variable en fonction d'un signal d'un dispositif de réglage.

5. Dispositif d'éclairage par lithographie selon l'une quelconque des revendications 1 à 4, dans lequel les moyens optiques comprennent au moins un système de lentilles condenseur aplatanique et asphérique.

6. Dispositif d'éclairage par lithographie selon l'une quelconque des revendications précédentes, dans lequel les moyens optiques comprennent au moins partiellement des lentilles étant produits à partir de verre de borosilicate, BK7 ou SF10, respectivement, les lentilles ayant de préférence un taux de transmission de > 90% dans la gamme spectrale des 350 nm à 1000 nm.

7. Dispositif d'éclairage par lithographie selon l'une quelconque des revendications précédentes, dans lequel le dispositif de mouvement est adapté pour

   (a) permettre un mouvement relatif dans deux dimensions, de préférence parallèlement au substrat (20), et/ou
   (b) permettre un mouvement relatif dans trois dimensions, de préférence parallèlement et verticalement au substrat (20).

8. Dispositif d'éclairage par lithographie selon l'une quelconque des revendications précédentes, dans lequel la source de lumière comprend plusieurs diodes lumineuses (2) émettant de la lumière UV pouvant de préférence être réglées individuellement, dans lequel la lumière émis des plusieurs diodes lumineuses (2) est parallisée par (i) un assemblage de microlentilles et/ou (ii) un assemblage plan de lentilles convexes avant d'être focalisée sur la tache lumineuse.

9. Dispositif d'éclairage par lithographie selon l'une quelconque des revendications précédentes, dans lequel au moins un dispositif d'éclairage (10) est agencé au dessus du substrat (20) et au moins un dispositif d'éclairage (10) est agencé au dessous du substrat (20) pour un éclairage du substrat (20) de deux côtés, dans lequel les deux dispositifs d'éclairage (10) peuvent de préférence être agités indépendamment l'un de l'autre.

10. Dispositif d'éclairage par lithographie selon l'une quelconque des revendications précédentes avec un dispositif d'ajustage (22, 23, 24, 25) pour ajuster la tache lumineuse ou le point de focalisation, respectivement, sur le substrat (20), dans lequel le dispositif d'ajustage comprend une photodiode (22) avec laquelle l'intensité de la lumière émis par le dispositif d'éclairage (10) est mesurée, et la distance entre le dispositif d'éclairage (10) et le substrat (20) est modifiée en fonction de l'intensité mesurée.

11. Dispositif d'éclairage par lithographie selon l'une quelconque des revendications précédentes comprenant un dispositif de fixation de substrat, comprenant :

au moins deux bords d'alignement (203) agencés sensiblement rectangulairement les uns aux autres, sur lesquels deux côtés d'un substrat rectangulaire peuvent être alignés ; et
une butée déplaçable (202), fixant le substrat (20) à au moins une troisième côté via un rail de guidage (201) et/ou via des éléments et/ou goupilles magnétiques.

12. Système pour produire un circuit imprimé comprenant:

- un dispositif d'éclairage par lithographie (42) selon l'une quelconque des revendications précédentes pour éclairer un substrat (20) comprenant une couche photosensible, et
- un dispositif de développement et de gravure pour développer et graver le substrat (20) éclairé par le dispositif d'éclairage par lithographie.

13. Procédé d'éclairage direct et structuré par lithographie d'un substrat (20) comprenant une couche photosensible comprenant les étapes :

- fournir un dispositif d'éclairage par lithographie (42) avec au moins un dispositif d'éclairage (10) comprenant une diode lumineuse émettant de la lumière UV (2) selon l'une quelconque des revendications 1 à 11,
- agencer le substrat (20) afin que la couche photosensible puisse être éclairée par la lumière émis par le dispositif d'éclairage (10),
- éclairer le substrat (20) avec le dispositif d'éclairage (10).

14. Procédé selon la revendication 13, dans lequel le dispositif d'éclairage (10) est déplacé par un mouvement d'avance linéaire le long d'un premier axe relatif au substrat et le dispositif d'éclairage (10) est déplacé relativement linéairement le long d'un deuxième axe, qui est sensiblement vertical au premier axe, dans lequel l'intensité de la lumière émis peut être variée durant le mouvement le long du deuxième axe afin d'éclairer des structures.

15. Procédé selon la revendication 13 ou 14, dans lequel la distance entre le dispositif d'éclairage (10) et le substrat (20) au cours de l'éclairage est variable, ce qui varie la taille de la tache lumineuse focalisée sur le substrat qui peut éclairer des lignes de différente largeur au cours d' un mouvement relatif.

16. Procédé selon l'une quelconque des revendications 13 à 15, dans lequel un substrat (20) revêtu des deux côtés est éclairé sur une couche supérieure par un premier dispositif d'éclairage (10) et sur une couche inférieure par un second dispositif d'éclairage (10), dans lequel les premier et second dispositifs d'éclairage (10) sont déplacés indépendamment l'un de l'autre.

17. Procédé selon l'une quelconque des revendications 13 à 16 comprenant les étapes supplémentaires :

- éclairage d'au moins un cadre autour d'une structure éclairé sur le substrat,
- développer et graver le substrat éclairé entier, dans lequel seulement un substrat résiduel reste sur les cadres éclairés ; et
- diviser le substrat le long de l'au moins un cadre en éliminant le substrat résiduel dans les cadres par couches à l'aide de la lumière du dispositif d'éclairage (10) et/ou d'un dispositif d'éclairage supplémentaire.

Figur 1

51

52

20

42

10

21

X

Y

Figur 2

Figur 3

Figur 4

**Fig. 5**

Fig. 7

Figur 6

Figur 8

**Fig. 9**

**Fig. 10**

**Fig. 11**

**Fig. 12**

**Fig. 13**

**Fig. 14**

**Fig. 15**

10

25

Z-Position
Offset
Regulation

73

20

22

21

A / D
Conversion

User
Software
interface /
Database

23

24

**Fig. 16**

**Fig. 17**

**Fig. 18**

202       10       200

**Fig. 19**

**Fig. 20**

**Fig. 21**

**Fig. 22**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9800760 A
- EP 1319984 A
- US 5745296 A